# EUROPEAN PATENT SPECIFICATION

(11) **EP 1 449 650 B1**
(45) Date of publication and mention of the grant of the patent: **11.04.2012**
(21) Application number: 04003843.2
(22) Date of filing: 20.02.2004
(51) Int. Cl.: B41C 1/10, B41M 5/36

(54) **Photosensitive composition and planographic printing plate precursor using the same**
Lichtempfindliche Zusammensetzung und damit hergestellte Flachdruckplatten-Vorstufe
Composition photosensible et précurseur de plaque d'impression planographique fabriqué avec cette composition

(30) Priority: 21.02.2003 JP 2003044091
(43) Date of publication of application: 25.08.2004
(73) Proprietor: FUJIFILM Corporation, Minato-ku Tokyo (JP)
(72) Inventor: Goto, Takahiro, c/o FUJI PHOTO FILM CO., LTD., Haibara-gun, Shizuoka-ken (JP)
(74) Representative: HOFFMANN EITLE

(56) References cited:
- EP-A- 1 110 747
- EP-A- 1 176 467
- EP-A- 1 241 002
- EP-A- 1 332 870
- EP-A- 1 369 231
- EP-A- 1 400 851
- EP-A- 1 450 207

## Description

### BACKGROUND OF THE INVENTION

### Field of the Invention

The present invention relates to a photosensitive composition and a planographic printing plate precursor using the same. More specifically, the present invention relates to a photosensitive composition useful as a photosensitive layer in a negative planographic printing plate precursor and a negative planographic printing plate precursor using the photosensitive composition.

### Description of the Related Art

Conventionally, a plate having a lipophilic photosensitive resin layer provided on a hydrophilic substrate has been used widely as a planographic printing plate precursor, and a desired printing plate is obtained by a plate-making method which usually involves masked light exposure (surface light exposure) via a lithographic film and then removing non-image regions by dissolution.

In recent years, digitalization techniques which involve electronic processing, accumulation and output of image information with a computer are spreading. A wide variety of new image output systems compatible with the digitalization techniques came to be practically used. As a result, there has been demand for computer-to-plate (CTP) techniques of producing a printing plate directly by scanning a highly directional light such as a laser light according to digitalized image information without a lithographic film, and it is an important technical problem to provide a planographic printing plate precursor adapted to these techniques.

As the planographic printing plate precursor capable of such scanning exposure to light, a planographic printing plate precursor comprising a hydrophilic substrate provided thereon with a lipophilic photosensitive resin layer (also referred to as the photosensitive layer) containing a photosensitive compound capable of generating active species such as radicals or Brønsted acid upon exposure to a laser light has proposed and brought to market. This planographic printing plate precursor is subjected to laser scanning according to digital information to generate active species acting on the photosensitive layer to cause physical or chemical change, thus making the layer insoluble, and then subjected to development treatment to give a negative planographic printing plate.

A planographic printing plate precursor wherein a photopolymerizable photosensitive layer containing a photopolymerization initiator excellent in photosensitization speed, an ethylenically unsaturated compound capable of addition polymerization, and a binder polymer soluble in an alkali developing solution, and if necessary an oxygen-impermeable protective layer, are disposed on a hydrophilic substrate is known (see, for example, Japanese Patent Application Laid-Open (JP-A) No. 10-195119). This planographic printing plate precursor is superior in productivity, can be easily developed, and is excellent in resolution and inking property, and can thus be used to produce a printing plate having desired printing performance.

As the binder polymer, organic polymers capable of alkali development, such as methacrylic acid copolymers, acrylic acid copolymers, itaconic acid copolymers, crotonic acid copolymers, maleic acid copolymers, and partially esterified maleic acid copolymers have been used (see, for example, JP-A Nos. 59-44615, Japanese Patent Application Publication (JP-B) Nos. 54-34327, 58-12577, 54-25957, JP-A Nos. 54-92723, 59-53836, 59-71048 and 2002-40652).

For improvements of coating property, stability with time and printing durability, techniques wherein polyurethane resin having an allyl group is contained as a binder polymer are disclosed (see, for example, Japanese Patent No. 2712564).

EP 1 450 207 A1 describes a planographic printing plate precursor, including a substrate, a photosensitive layer containing an IR absorber, a polymerization initiator, a polymerizable compound and a binder polymer, and a protective layer containing a UV absorber, disposed in this order. The photosensitive layer is formed by using a coating solution contains, *inter alia*, a sulfonium salt polymerization initiator and polymerizable compounds having a urethane skeleton.

At present, however, a photosensitive composition capable of high sensitive recording, excellent in storage stability (raw stock storability) and capable of high printing resistance upon application to a negative planographic precursor is not obtained.

### SUMMARY OF THE INVENTION

The present invention is to solve the problems in the related art described above, and to achieve the following objects.

A first object of the present invention is to provide a photosensitive composition which is highly sensitive, excellent in storage stability (raw stock storability) and useful as a photosensitive layer of a negative planographic printing plate precursor.

A second object of the present invention is to provide a negative planographic printing plate precursor which is capable of highly sensitive recording with an infrared laser and excellent in storage stability (row stock storability) and printing durability.

The objects have been achieved by the following photosensitive composition and the planographic printing plate precursor comprising the photosensitive composition in a photosensitive layer.

A first aspect of the present invention is to provide a photosensitive composition comprising an infrared absorbing agent, a sulfonium salt polymerization initiator, a polymerizable compound having a urethane skeleton and a binder polymer.

A second aspect of the present invention is to provide a planographic printing plate precursor comprising a photosensitive layer disposed on a substrate, wherein the photosensitive layer including the photosensitive composition of the present invention. The planographic printing plate precursor preferably has a protective layer. The photosensitive layer and the protective layer are disposed on the substrate in this order.

The phrase "disposed on a substrate in this order" means a photosensitive layer and a protective layer are arranged on a substrate in this order, but this phrase dose not deny the presence of other layers (for example, an intermediate layer, a back coat layer, etc.) arranged in accordance with specific objects.

### BRIEF DESCRIPTION OF THE DRAWINGS

Fig. 1 is a schematic diagram showing one example of DRM interference wave measuring instrument for measuring dissolution behavior of a photosensitive layer.
Fig. 2 is schematic diagram showing one example of measuring electrostatic capacity used in evaluating the permeation of a developing solution into the photosensitive layer.
Fig. 3 is a side view showing the concept of a brush graining step used in mechanical surface roughening treatment in preparation of a substrate of a planographic printing plate precursor of the present invention.
Fig. 4 is a graph showing one example of an alternating waveform electric current waveform used in electrochemical surface roughening treatment in preparation of the substrate of the planographic printing plate precursor of the present invention.
Fig. 5 is a side view showing one example of a radical cell used in electrochemical surface roughening treatment using an alternating current in preparation of the substrate of the planographic printing plate precursor of the present invention.
Fig. 6 is schematic diagram of an anodizing device used in anodizing treatment in preparation of the substrate of the planographic printing plate precursor of the present invention.

### DETAILED DESCRIPTION OF THE INVENTION

Hereinafter, the photosensitive composition and the planographic printing plate precursor of the present inventions will be described in more detail.

### [Photosensitive composition]

The photosensitive composition of the present invention comprises an infrared absorbing agent, a sulfonium salt polymerization initiator, a polymerizable compound having a urethane skeleton and a binder polymer, wherein the composition comprises a sulfonium salt polymerization initiator and a polymerizable compound having a urethane skeleton, characterized in that the sulfonium salt polymerization initiator is an onium salt represented by the following general formula (I): General formula (I) 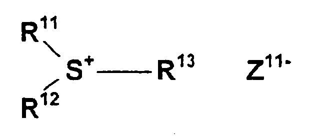 wherein R¹¹, R¹² and R¹³ each represent parachlorophenyl group; and Z¹¹⁻ represents a counterion selected from the group consisting of a carboxylate ion and a sulfonate ion, with the proviso that in the photosensitive composition the following compound (1) may not be contained in combination with the following compound (2): 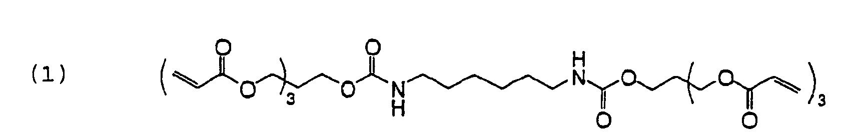 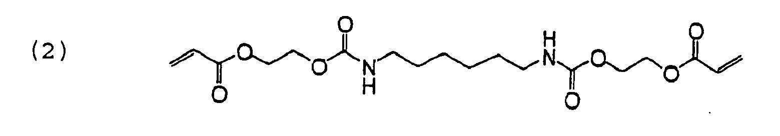 .

Hereinafter, the respective components contained in the photosensitive composition are described.

### (Polymerizable compound having a urethane skeleton)

The photosensitive composition of the present invention comprises a polymerizable compound having a urethane skeleton.

The polymerizable compound having a urethane skeleton is an addition-polymerizable compound having at least one urethane linkage and at least one ethylenically unsaturated bond. The polymerizable compound may have at least one urethane linkage, and may also have two or more linkages. The polymerizable compound has two or more ethylenically unsaturated bonds. The polymerizable compound occurs in chemical forms such as monomers, prepolymers, that is, dimers, trimers and oligomers, as well as mixtures and copolymers thereof.

The polymerizable compound having a urethane skeleton according to the present invention is preferably a urethane type addition polymerizable compound produced by using an addition reaction of an isocyanate with a hydroxyl group, and examples thereof include vinyl urethane compounds containing two or more polymerizable vinyl groups in one molecule, which are prepared by adding vinyl monomers containing a hydroxyl group shown in formula (1) below to polyisocyanates having two or more isocyanate groups in one molecule as described in JP-B 48-41708.

CH₂ = C(R₄)COOCH₂CH(R₅)OH (1)

In formula (1) R₄ and R₅ each independently represent H or CH₃.

The urethane acrylates as described in JP-A No. 51-37193, JP-B Nos. 2-32293 and 2-16765, and the urethane compounds having an ethylene oxide-type skeleton described in JP-B Nos. 58-49860, 56-17654, 62-39417 and 62-39418 are also preferable. Addition-polymerizable compounds having an amino structure or sulfide structure in the molecule as described in JP-A Nos. 63-277653, 63-260909 and 1-105238 can be used to prepare highly sensitive photopolymerizable compositions.

In addition to those described above, the respective compounds mentioned below are also preferably used in the photosensitive composition of the present invention. They are urethane acrylates M-1100, M-1200, M-1210 and M-1300 manufactured by Toagosei Co., Ltd., urethane acrylates EB210, EB4827, EB6700 and EB220 manufactured by Daicel U.C.B., UVITHANE-782, UVITHANE-783, UVITHANE-788 and UVITHANE-893 manufactured by MORTON THIOKOL Inc., Art Resin UN-9000EP, Art Resin UN-9200A, Art Resin UN-9000H, Art Resin UN-1255, Art Resin UN-5000, Art Resin UN-2111A, Art Resin UN-2500, Art Resin UN-3320HA, Art Resin UN-3320HB, Art Resin UN-3320HC, Art Resin UN-3320HS, Art Resin UN-6060P, Art Resin UN-6060PTM, Art Resin SH-380G, Art Resin SH-500 and Art Resin SH-9832 manufactured by Negami Kogyo Co., Ltd., NK oligo U-4H, NK oligo U-4HA, NK oligo U-4P, NK oligo U-4PA, NK oligo U-4TX, NK oligo U-4TXA, NK oligo U-6LHA, NK oligo-6LPA-N, NK oligo U-6LTXA, NK oligo UA-6ELP, NK oligo UA-6ELH, NK oligo UA-6ELTX, NK oligo UA-6PLP, NK oligo U-6ELP, NK oligo U-6ELH, NK oligo-8MDA, NK oligo U-8MD, NK oligo U-12LMA, NK oligo U-12LM, NK oligo U-6HA, NK oligo U-108A, NK oligo U-1084A, NK oligo U-200AX, NK oligo U-122A, NK oligo U-340A, NK oligo U-324A and NK oligo UA-100 manufactured by Shin-Nakamura Chemical Co., Ltd., AH-600, AT-600, UA-306H, AI-600, UA-101T, UA101I, UA-101H, UA-306T, UA-306I, UF-8001 and UF-8003 manufactured by Kyoeisha Chemical Co., Ltd.

Hereinafter, examples (M-1 to M-27) of the polymerizable compound having a urethane skeleton used preferably in the present invention are described, but the present invention is not limited thereto.

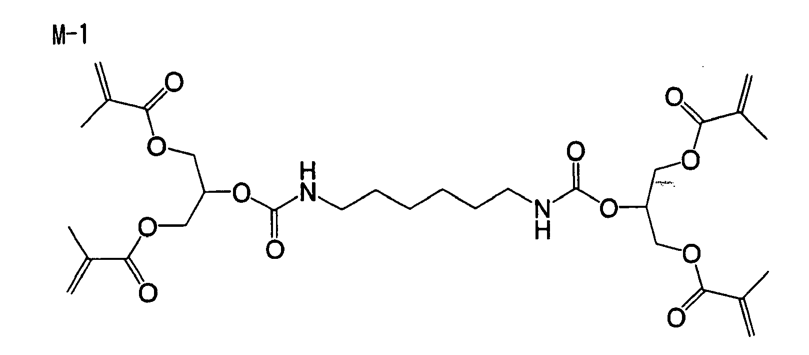

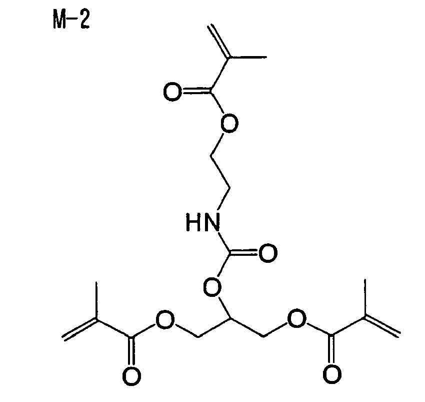

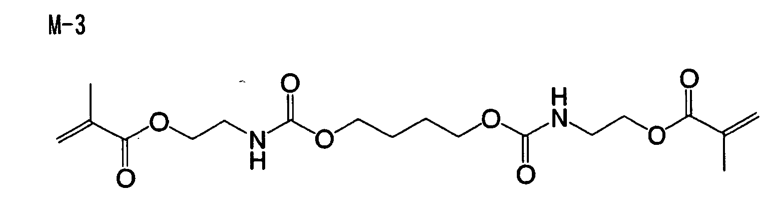

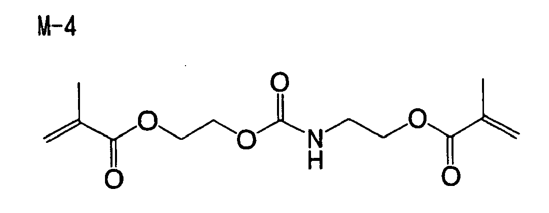

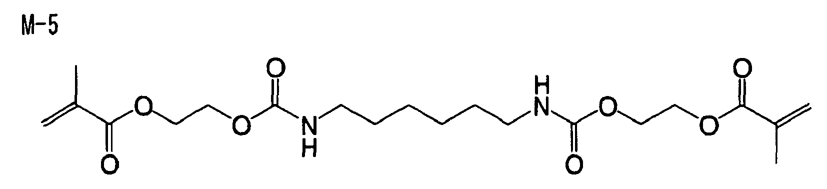

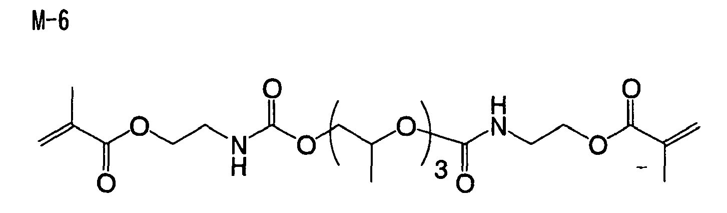

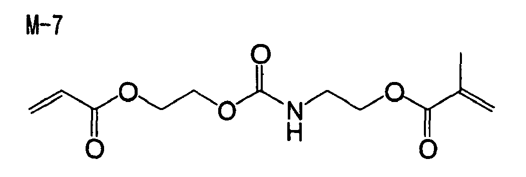

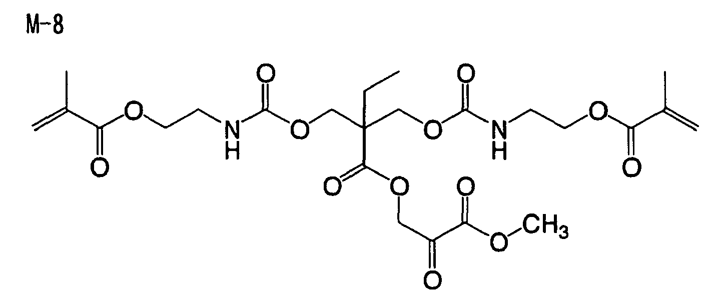

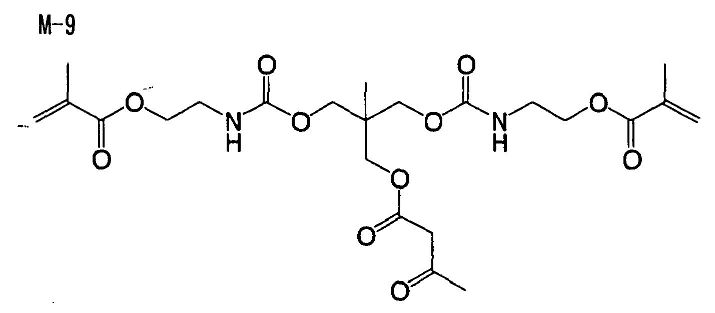

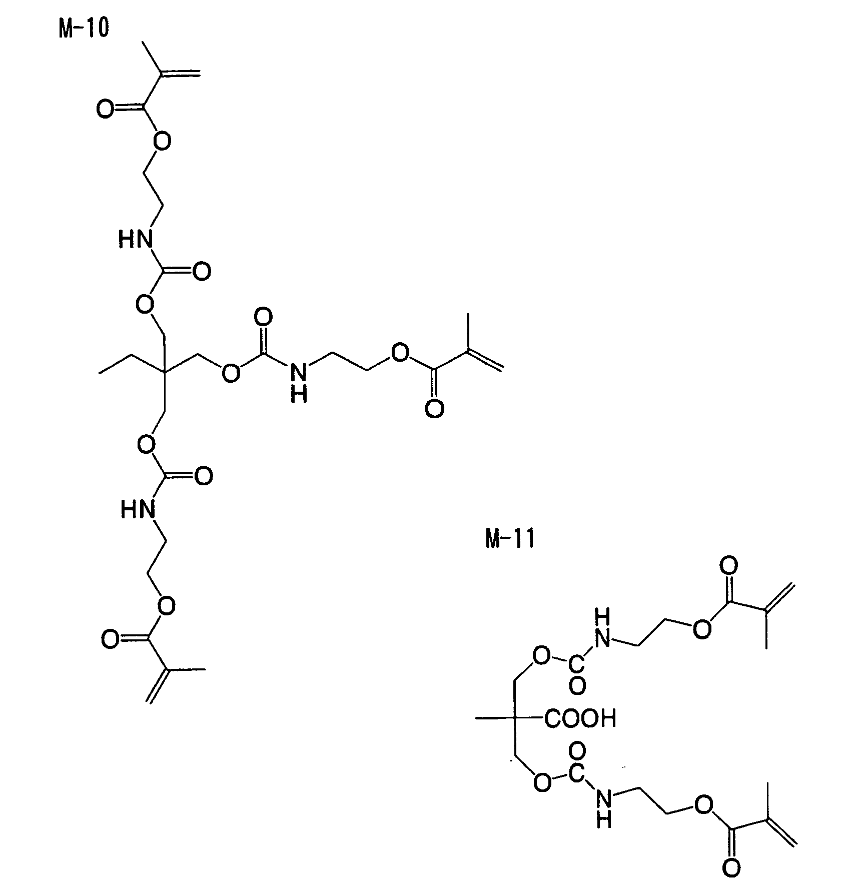

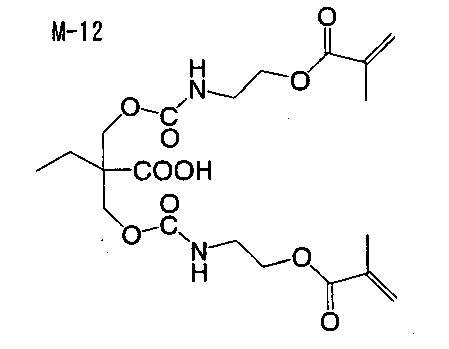

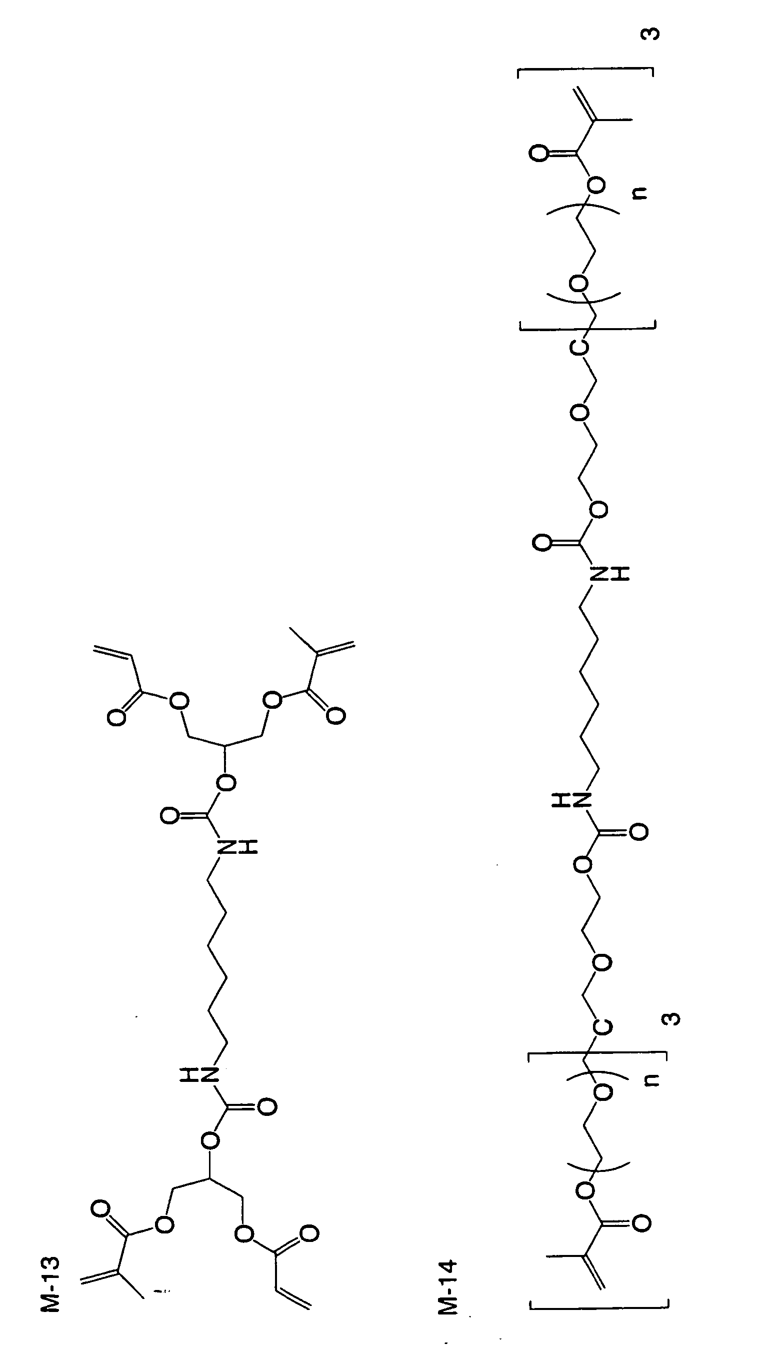

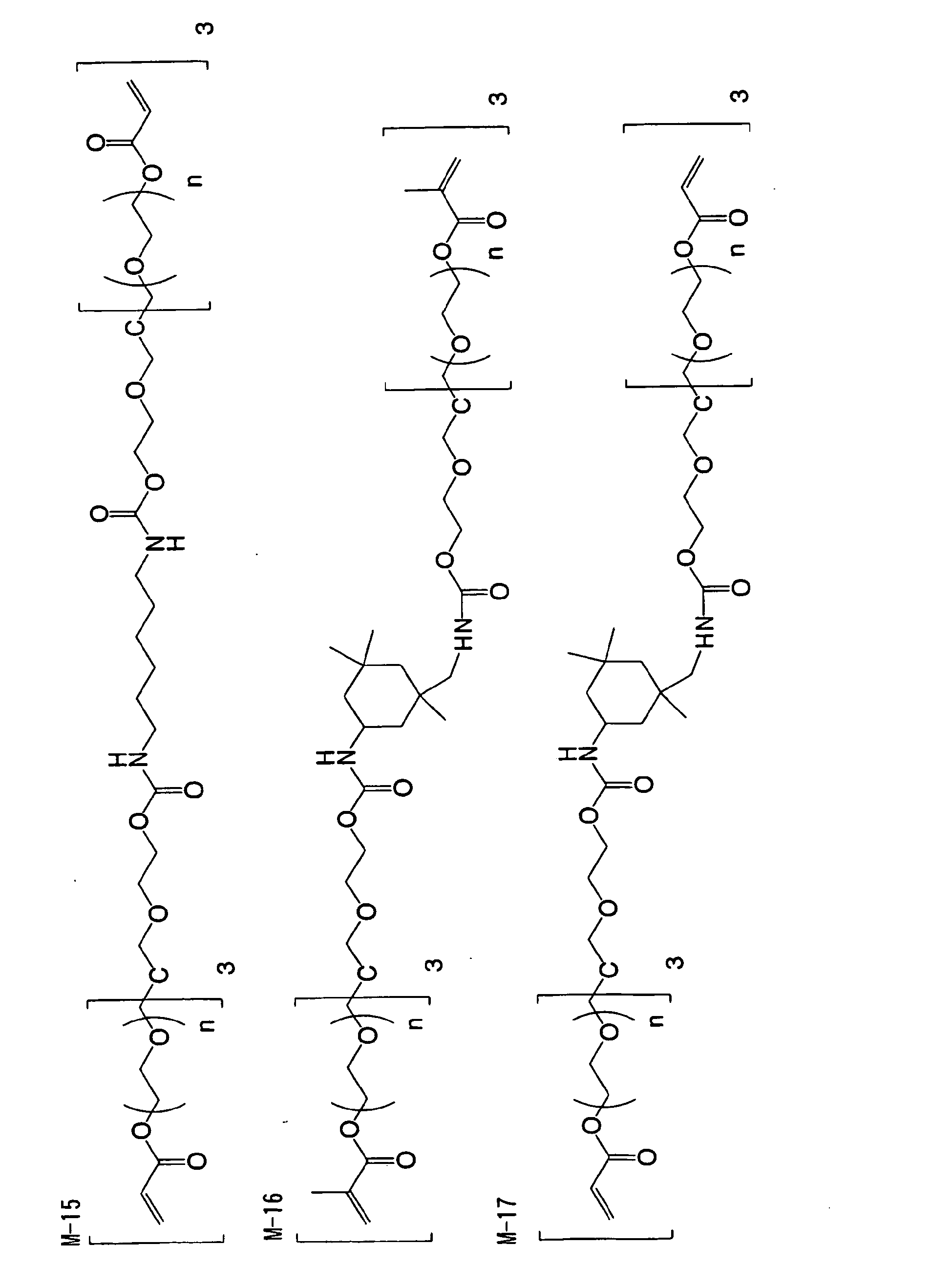

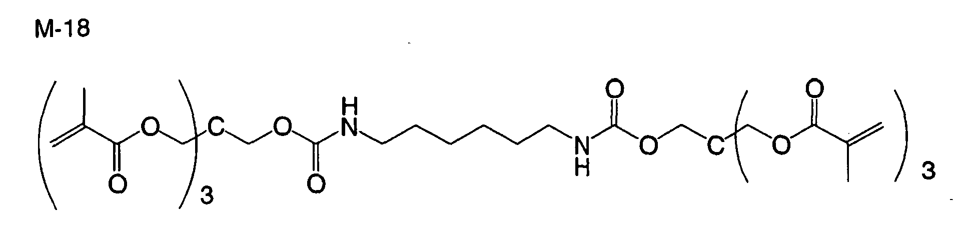

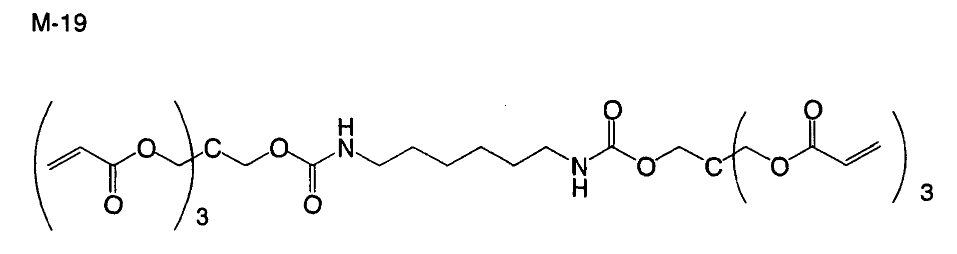

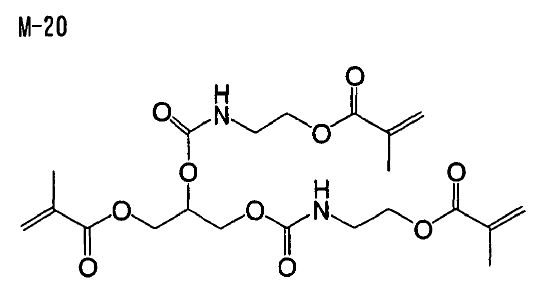

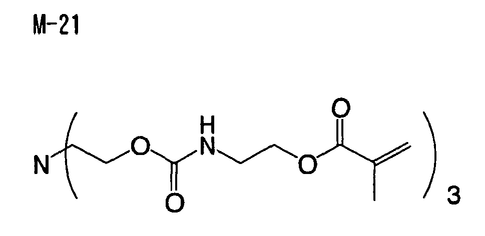

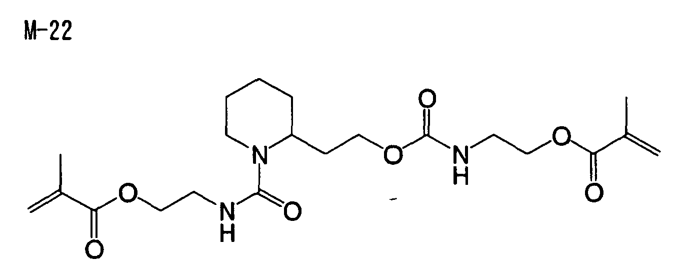

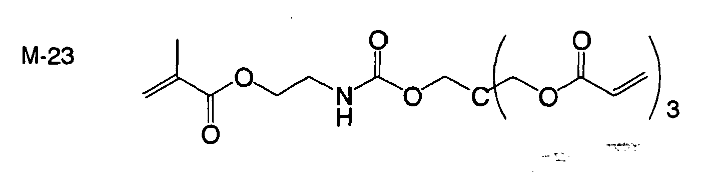

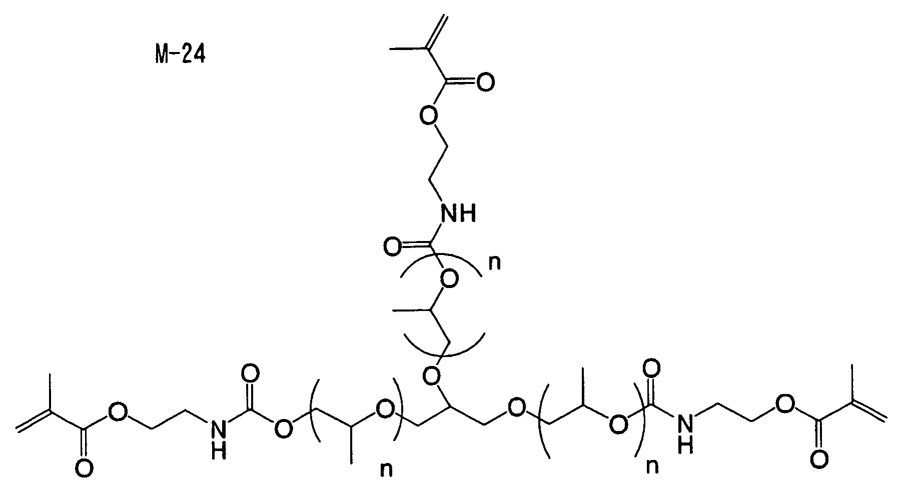

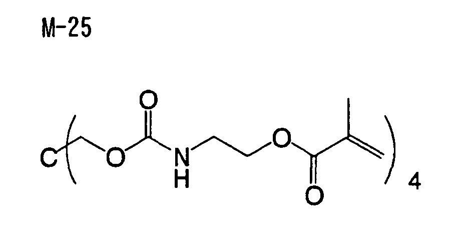

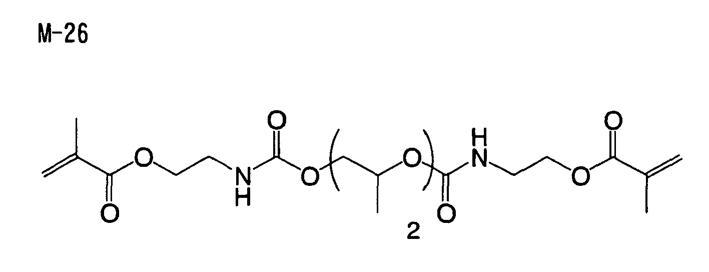

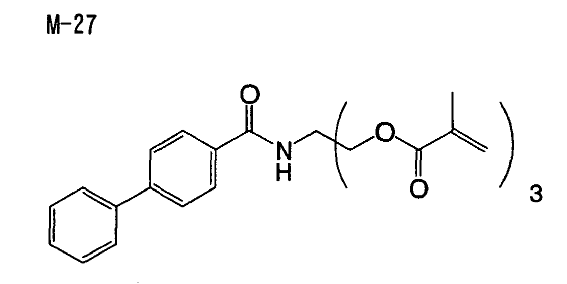

The polymerizable compounds having a urethane skeleton according to the present invention may be used alone or in combination thereof. The polymerizable compounds having a urethane skeleton may be used alone or in combination with other polymerizable compound(s) described later.

The ratio of the polymerizable compound blended in the photosensitive composition is advantageously higher for sensitivity, but if the ratio is too high, this causes undesirable phase separation, problems in process caused by the adhesion of the photosensitive layer (e.g., defects in process caused by transfer and adhesion of components in the photosensitive layer), and precipitation from the developing solution. From these viewpoints, total amount of the addition-polymerizable compounds (i.e. the addition-polymerizable compounds having a urethane skeleton and the optional used other addition-polymerizable compound(s)) is preferably 5 to 80% by mass, more preferably 25 to 75% by mass, based on nonvolatile components in the photosensitive layer. The ratio (ratio by mass) of the polymerizable compound having a urethane skeleton to other polymerizable compound(s) is preferably 10/1 to 10 / 4, more preferably 10/1 to 10/2.

### -Other polymerizable compounds that can be simultaneously used-

The other polymerizable compound which can be used in combination with the polymerizable compound having a urethane skeleton in the present invention is an addition-polymerizable compound at least one ethylenically unsaturated bond. The addition-polymerizable compound is selected from compounds each having at least one (preferably two or more) ethylenically unsaturated bond(s). A group of such compounds is known widely in the industry, and in the present invention, these compounds can be used without any particular limitation. These compounds occur in chemical forms such as monomers, prepolymers, that is, dimers, trimers and oligomers, as well as mixtures and copolymers thereof. Examples of such monomers and copolymers include unsaturated carboxylic acids (e.g., acrylic acid, methacrylic acid, itaconic acid, crotonic acid, isocrotonic acid, maleic acid, etc.) and esters and amides thereof, and preferably used among these compounds are esters between unsaturated carboxylic acids and aliphatic polyvalent alcohols and amides between unsaturated carboxylic acids and aliphatic polyvalent amines. Also preferably used among these compounds are unsaturated carboxylates having nucleophilic substituent groups such as a hydroxyl group, amino group, mercapto group, etc., addition-reaction products of amides with monofunctional or multifunctional isocyanates or epoxy compounds, and dehydration condensation reaction products of amides with monofunctional or multifunctional carboxylic acids. Also preferably used among these compounds are unsaturated carboxylates having electrophilic substituent groups such as an isocyanate group, epoxy group, etc., addition-reaction products of amides with monofunctional or multifunctional alcohols, amines or thiols; unsaturated carboxylates having releasing substituent groups such as a halogen atom, tosyloxy group, etc.; and substitution-reaction products of amides with monofunctional or multifunctional alcohols, amines or thiols. Use can also be made of a group of those compounds wherein the above-described carboxylic acids have been replaced by unsaturated phosphonic acids, styrene, vinyl ethers, etc.

As the ester monomers between aliphatic polyvalent alcohols and unsaturated carboxylic acids, the acrylates include ethylene glycol diacrylate, triethylene glycol diacrylate, 1,3-butane diol diacrylate, tetramethylene glycol diacrylate, propylene glycol diacrylate, neopentyl glycol diacrylate, trimethylol propane triacrylate, trimethylol propane tri(acryloyloxypropyl)ether, trimethylol ethane triacrylate, hexane diol diacrylate, 1,4-cyclohexane diol diacrylate, tetraethylene glycol diacrylate, pentaerythritol diacrylate, pentaerythritol triacrylate, pentaerythritol tetracrylate, dipentaerythritol diacrylate, dipentaerythritol hexacrylate, sorbitol triacrylate, sorbitol tetracrylate, sorbitol pentacrylate, sorbitol hexacrylate, tri(acryloyloxyethyl) isocyanurate, polyester acrylate oligomers, etc.

The methacrylates include tetramethylene glycol dimethacrylate, triethylene glycol dimethacrylate, neopentyl glycol dimethacrylate, trimethylol propane trimethacrylate, trimethylol ethane trimethacrylate, ethylene glycol dimethacrylate, 1,3-butane diol dimethacrylate, hexane diol dimethacrylate, pentaerythritol dimethacrylate, pentaerythritol trimethacrylate, pentaerythritol tetramethacrylate, dipentaerythritol dimethacrylate, dipentaerythritol hexamethacrylate, sorbitol trimethacrylate, sorbitol tetramethacrylate, bis[p-(3-methacryloxy-2-hydroxypropoxy)phenyl]dimethyl methane, bis[p-(methacryloxyethoxy)phenyl]dimethyl methane, etc.

The itaconates include ethylene glycol diitaconate, propylene glycol diitaconate, 1,3-butane diol diitaconate, 1,4-butane diol diitaconate, tetramethylene glycol diitaconate, pentaerythritol diitaconate, sorbitol tetraitaconate, etc. The crotonates include ethylene glycol dicrotonate, tetramethylene glycol dicrotonate, pentaerythritol dicrotonate, sorbitol tetradicrotonate, etc. The isocrotonates include ethylene glycol diisocrotonate, pentaerythritol diisocrotonate, sorbitol tetraisocrotonate, etc. The maleates include ethylene glycol dimaleate, triethylene glycol dimaleate, pentaerythritol dimaleate, sorbitol tetramaleate, etc.

Other preferably used esters include, for example, aliphatic alcohol-based esters as described in JP-B Nos. 46-27926, 51-47334 and JP-A No. 57-196231; those having an aromatic skeleton as described in JP-A Nos. 59-5240, 59-5241 and 2-226149; and those having an amino group described in JP-A No. 1-165613. The ester monomers can also be used as a mixture.

As the monomers, the amides between aliphatic polyvalent amines and unsaturated carboxylic acids include methylene bisacrylamide, methylene bis-methacrylamide, 1,6-hexamethylene bisacrylamide, 1,6-hexamethylene bis-methacrylamide, diethylene triamine trisacrylamide, xylylene bisacrylamide, xylylene bismethacrylamide, etc. Preferable examples of other amide type monomers include those having a cyclohexylene structure described in JP-B No. 54-21726.

Other examples include multifunctional acrylates and methacrylates such as polysesteracrylates and the epoxy acrylates obtained by reacting epoxy resin with (meth)acrylic acid as described in JP-A No. 48-64183, JP-B Nos. 49-43191 and 52-30490, respectively. Specific unsaturated compounds as described in JP-B Nos. 46-43946, 1-40337 and 1-40336, and vinyl phosphonic acid-type compounds as described in JP-A No. 2-25493 can also be mentioned. In some cases, a structure containing a perfluoroalkyl group as described in JP-A No. 61-22048 is preferably used. The photosetting monomers and oligomers described in the Journal of Japanese Adhesive Society, vol. 20, No. 7, pp. 300-308 (1984) can also be used.

Details of method of using these addition-polymerizable compounds, for example, the structure thereof , single use or use in combination thereof, and the amount to be used, can be arbitrarily determined depending on the desired performance and design of the final material insofar as the polymerizable compound having a urethane skeleton is used as an essential component.

For example, they are selected from the following viewpoints. From the viewpoint of photosensitizing speed, the additional-polymerizable compounds preferably have many unsaturated groups in one molecule, and in many cases, they are preferably bifunctional or more. In order to increase the strength of image areas, i.e., the cured layer, the compounds are preferably trifunctional or more. It is also effective to use a method of controlling both photosensitivity and layer strength by combined use of compounds (e.g., acrylates, methacrylates, styrene type compounds, and vinyl ether type compounds) having different functionalities and different polymerizable groups. The high-molecular compounds or highly hydrophobic compounds, though being excellent in photosensitivity and layer strength, may be undesirable in some cases when considering developing speed and precipitation in the developing solution. The method of selecting and using the addition-polymerizable compound is an important factor for compatibility and dispersibility with other components (e.g., a binder polymer, an initiator, a coloring agent, etc.) in the photosensitive layer, and the compatibility may be improved by, for example, using a low-purity compound or a combination of two or more compounds. When the photosensitive composition is used in a planographic printing plate precursor, a specific structure can be selected for the purpose of improving adhesiveness to a substrate or an overcoat layer, described later.

From the viewpoints of the degree of inhibition of polymerization by oxygen, resolution, fogging, a change in reflectance, and surface adhesion, a suitable structure, compounding and amount thereof can be arbitrarily selected in the method of using the addition-polymerizable compound. When the photosensitive composition is used in a planographic printing plate precursor, a layer structure and a coating method such as undercoating and overcoating can also be carried out as necessary.

### (Infrared absorbing agent)

It is essential that an infrared absorbing agent is used in the photosensitive composition of the present invention. The infrared absorbing agent has a function of converting absorbed infrared rays into heat. By this generated heat, a polymerization initiator (radical generating agent) described later is thermally decomposed to generate radicals. The infrared absorbing agent used in the present invention is preferably a dye or pigment having an absorption maximum at a wavelength in the range of 760 to 1,200 nm.

The dye may be any known commercial dye including those described in publications such as *Senryo Binran* (Dye Handbook) (published in 1970 and compiled by the Society of Synthetic Organic Chemistry, Japan). Examples of such dyes include azo dyes, metal complex salt azo dyes, pyrazolone azo dyes, naphthoquinone dyes, anthraquinone dyes, phthalocyanine dyes, carbonium dyes, quinone imine dyes, methine dyes, cyanine dyes, squarylium dyes, pyrylium salts, and metal thiolate complexes.

Preferable dyes include cyanine dyes such as those described in patent documents such as JP-A Nos. 58-125246, 59-84356, 59-202829, and 60-78787, and the methine dyes described in JP-A Nos. 58-173696, 58-181690, 58-194595, etc.. Further, the naphthoquinone dyes described in JP-A Nos. 58-112793, 58-224793, 59-48187, 59-73996, 60-52940, 60-63744, etc., the squarylium dyes described in JP-A No. 58-112792, etc., and the cyanine dyes described in Britsh Patent No. 434,875 are also preferably used.

The near infrared ray-absorbing sensitizers described in US Patent No. 5,156,938 are also preferably used. Also preferably used are the substituted aryl benzo(thio) pyrylium salts described in US Patent No. 3,881,924; the trimethine thiapyrylium salts described in JP-A No. 57-142645 (US Patent No. 4,327,169); the pyrylium type compounds described in JP-A Nos. 58-181051, 58-220143, 59-41363, 59-84248, 59-84249, 59-146063, and 59-146061; the cyanine dyes described in JP-A No. 59-216146; the pentamethine thiopyrylium salts described in US Patent No. 4,283,475; and the pyrylium compounds described in JP-B Nos. 5-13514 and 5-19702. Other preferable examples of the dyes include the near infrared ray-absorbing dyes of the general formulae (I) and (II) described in US Patent No. 4,756,993.

Other preferable examples of the infrared absorbing dye in the present invention include specific indolenine cyanine dyes described in Japanese Patent Application Nos. 2001-6326 and 2001-237840, as shown below.

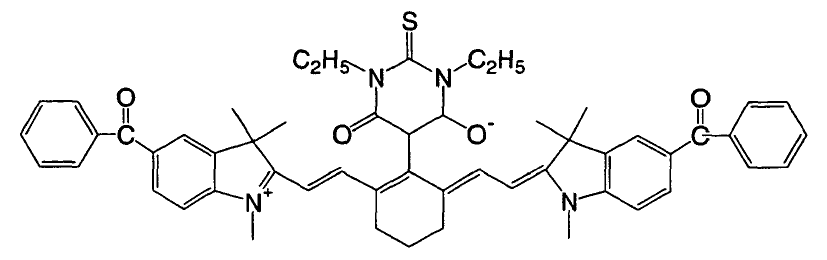

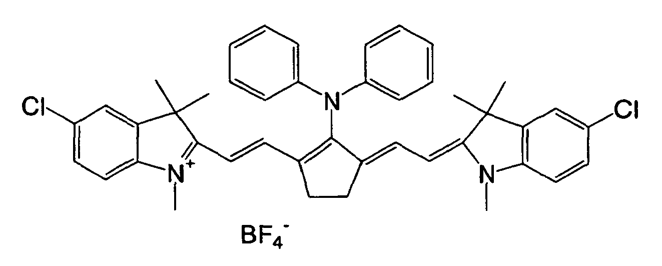

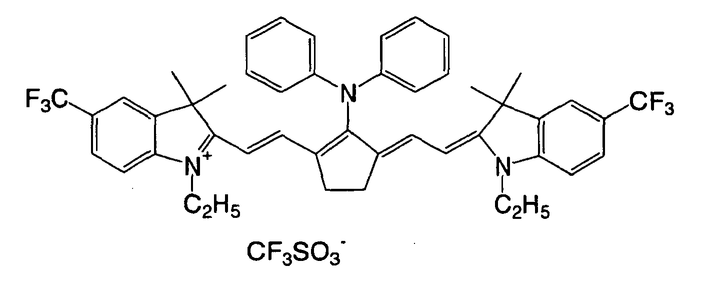

Particularly preferable among these dyes are cyanine dyes, squarylium dyes, pyrylium salts, nickelthiolate complexes and indolenine cyanine dyes. The dyes are more preferably cyanine dyes and indolenine cyanine dyes, still more preferably cyanine dyes represented by the following general formula (a).

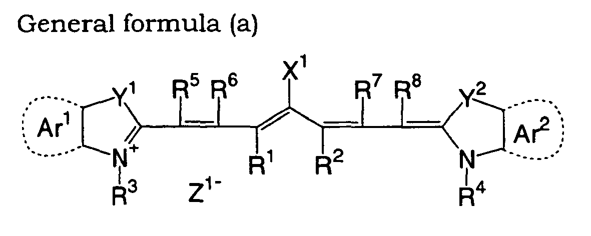

In the general formula (a), X¹ represents a hydrogen atom, a halogen atom, -NPh₂, X²-L¹ or a group shown below. X² represents an oxygen atom, a nitrogen atom or a sulfur atom, L¹ represents a hydrocarbon group having 1 to 12 carbon atoms, an aromatic ring having a heteroatom, and a hydrocarbon group having 1 to 12 carbon atoms containing a heteroatom. The heteroatom refers to N, S, O, halogen atom or Se. Xa⁻ has the same meaning as that of Z¹⁻ defined later, and R^{a} represents a substituent group selected from a hydrogen atom, an alkyl group, an aryl group, a substituted or unsubstituted amino group, and a halogen atom.

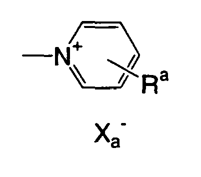

R¹ and R² independently represent a hydrocarbon group having 1 to 12 carbon atoms. For the purpose of storability of the coating solution of the recording layer, each of R¹ and R² is preferably a hydrocarbon group having 2 or more carbon atoms, and more preferably R¹ and R² are linked to each other to form a 5- or 6-memberred ring.

Ar¹ and Ar² may be the same or different and each represents an aromatic hydrocarbon group which may have a substituent group. The aromatic hydrocarbon group is preferably a benzene ring or a naphthalene ring. The substituent group is preferably a hydrocarbon group having 12 or less carbon atoms, a halogen atom or an alkoxy group having 12 or less carbon atoms. Y¹ and Y² may be the same or different and each represents a sulfur atom or a dialkyl methylene group having 12 or less carbon atoms. R³ and R⁴ may be the same or different and each represents a hydrocarbon group having 20 or less carbon atoms, which may have a substituent group. The substituent group is preferably an alkoxy group having 12 or less carbon atoms, a carboxyl group or a sulfo group. R⁵, R⁶, R⁷ and R⁸ may be the same or different and each represents a hydrogen atom or a hydrocarbon group having 12 or less carbon atoms. Each of R⁵, R⁶, R⁷ and R⁸ is preferably a hydrogen atom because the starting material is easily available. Za⁻ represents a counter anion. However, when the cyanine dye represented by the general formula (a) has an anionic substituent group in its structure and does not necessitate neutralization of the charge, Za⁻ is not necessary. For the purpose of storability of the coating solution of the recording layer, Za⁻ is preferably a halogen ion, a perchlorate ion, a tetrafluoroborate ion, a hexafluorophosphate ion or a sulfonate ion, particularly preferably a perchlorate ion, a hexafluorophosphate ion or an aryl sulfonate ion.

Examples of the cyanine dyes represented by the general formula (a), which can be preferably used in the present invention, include those described in columns [0017] to [0019] in JP-A No. 2001-133969.

Other preferable examples of the infrared absorbing agent in the present invention include specific indolenine cyanine dyes described in Japanese Patent Application Nos. 2001-6326 and 2001-237840 supra.

The pigment includes commercial pigments and those described in the Color Index (C. I.) Handbook, *Saishin Ganryo Binran* (Latest Dye Handbook) (published in 1977 and compiled by the Japanese Society of Pigment Technology); *Saishin Ganryho* Oyo *Gijyutsu* (Latest Pigment Applied Technology) (published in 1986 by CMC Publishing Co., Ltd.); and *Insatsu Inki Gijyutsu* (Printing Ink Technology) (published in 1984 by CMC Publishing Co., Ltd.).

Examples of the pigment include black pigments, yellow pigments, orange pigments, brown pigments, red pigments, violet pigments, blue pigments, green pigments, fluorescent pigments, metallic powder pigments, and other pigments such as polymer-binding dyes. Specific examples of preferable pigments include insoluble azo pigments, azo lake pigments, condensed azo pigments, chelate azo pigments, phthalocyanine type pigments, anthraquinone type pigments, perylene and perinone type pigments, thioindigo type pigments, quinacridone type pigments, dioxazine type pigments, isoindolinone type pigments, quinophthalone type pigments, dyed lake pigments, azine pigments, nitroso pigments, nitro pigments, natural pigments, fluorescent pigments, inorganic pigments, and carbon black, which is preferable among these.

The pigments may or may not be subjected to surface treatment. Methods of surface treatment include coating the surface with resin or wax; allowing a surfactant to adhere to the surface; and bonding a reactive material (e.g., a silane coupling agent, an epoxy compound, a polyisocyanate, etc.) onto the surface of the pigment. These methods of surface treatment are described in *Kinzoku Sekken No Seishitsu To Oyo* (Properties and Application of Metallic Soap) (Sachi Shobo); *Insatsu Inki Gijyutsu* (Printing Ink Technology) (published in 1984 by CMC Publishing Co., Ltd.); and *Saishin Ganryho Oyo Gijyutsu* (Latest Pigment Applied Technology) (published in 1986 by CMC Publishing Co., Ltd.).

The particle diameters of the pigments are in the range of preferably 0.01 to 10 µm, more preferably 0.05 to 1 µm, most preferably 0.1 to 1 µm, from the viewpoint of stability in the coating solution or uniformity of the photosensitive layer.

In the method of dispersing the pigment, known dispersing machines used widely in production of inks or toners and dispersing techniques can be suitably selected. Examples of suitable dispersing machines include a supersonic dispersing device, sand mill, attritor, pearl mill, super mill, ball mill, impeller, disperser, KD mill, colloid mill, dynatron, triple roll mill, press kneader, etc. These are described in detail in the aforementioned *Saishin Ganryho Oyo Gijyutsu* (Latest Newest Pigment Applied Technology) (published in 1986 by CMC Publishing Co., Ltd.).

The aforementioned infrared absorbing agents, along with other components, may be added to the same layer or to a separately provided layer in the resultant negative planographic printing precursor such that the optical density of the photosensitive layer at the maximum absorption wavelength in the range of 760 to 1200 nm is in the range of 0.5 to 1.2 as a determined by a reflection measurement method. The optical density is preferably in the range of 0.6 to 1.15, from the viewpoint of sensitivity and curability of the formed film,.

The optical density of the photosensitive layer can be controlled by the amount of the infrared absorbing agent added to the photosensitive layer and the thickness of the photosensitive layer. The optical density can be measured in a usual manner. The measurement method includes, for example, a method wherein the photosensitive layer whose thickness is determined suitably in a necessary range after drying for the planographic printing plate precursor is formed on a reflective substrate such as aluminum, and then measured for reflection density by an optical densitometer, or a method of measuring density with a spectrophotometer by a reflection method using an integrating sphere.

These infrared absorbing agents can be added in a ratio of 0.01 to 50% by mass, more preferably 0.1 to 10% by mass, and as the infrared absorbing agent, the dye can be added in the range of 0.5 to 10% by mass, and the pigment can be added in the range of 0.1 to 10% by mass. In this range of the pigment or dye, high sensitivity is achieved, and a uniform coating excellent in durability can be formed.

### (Polymerization initiator)

As the polymerization initiator for initiation and promotion of the curing reaction of the polymerizable compound, a sulfonium salt polymerization initiator which is a thermally decomposed radical generating agent to be decomposed by heat to generate radicals is contained in the photosensitive composition of the present invention.

In the present invention, the sulfonium salt polymerization initiator is used in combination with the infrared absorbing agent described above to generate radicals by the heat converted from infrared rays absorbed by the infrared ray absorbing agent upon irradiation with an infrared laser. By this combination, heat-mode recording is feasible in the present invention.

The sulfonium salt polymerization initiator used in the present invention includes onium salts represented by the following general formula (I).

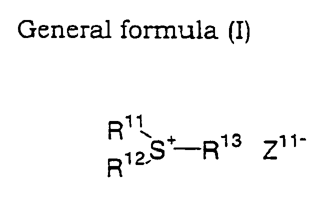

In the general formula (I), R¹¹, R¹² and R¹³ each independently represent parachlorophenyl group. Z¹¹⁻ represents a counterion selected from the group consisting of a carboxylate ion and a sulfonate ion.

Hereinafter, an example of the onium salts ([OS-10]) represented by the general formula (I) and reference examples ([OS-1] to [OS-9]) are mentioned, but the onium salts are not limited thereto.

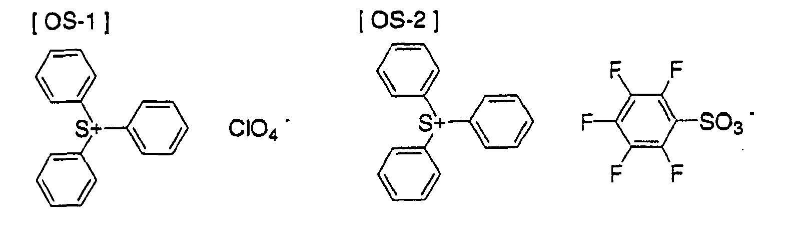

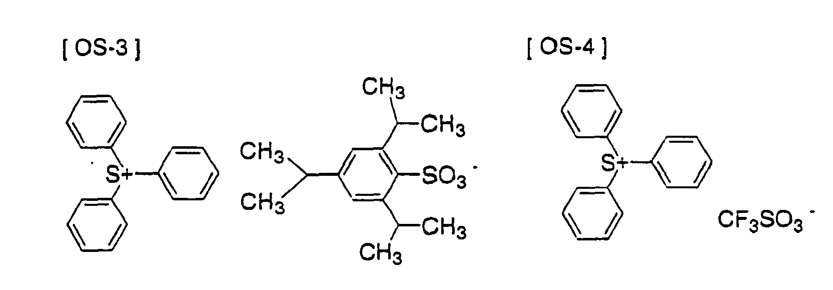

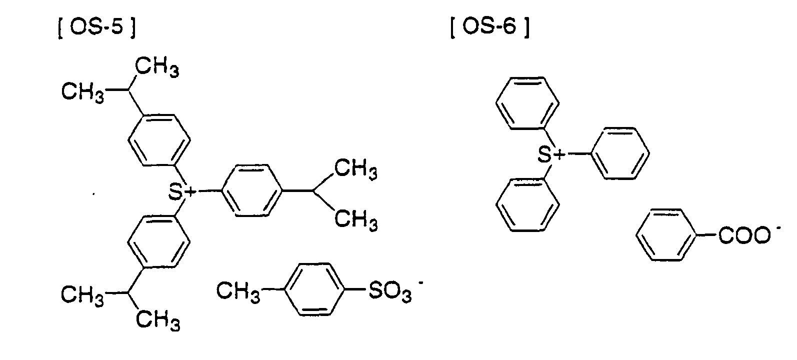

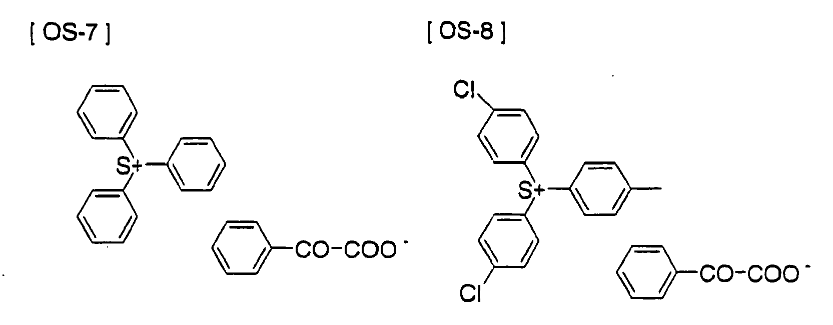

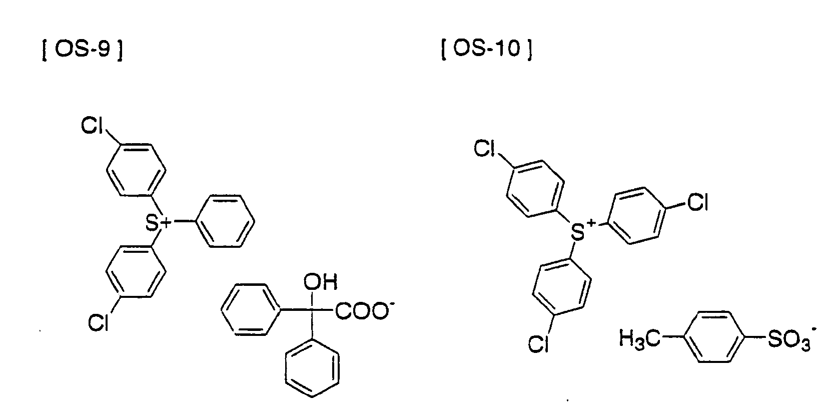

In addition to the reference examples described above, specific aromatic sulfonium salts described in JP-A Nos. 2002-148790, 2002-350207 and 2002-6482 can also be mentioned.

In the present invention, other polymerization initiators (other radical generating agents) can be used in combination with the sulfonium salt polymerization initiator contained as an essential component.

The other radical generating agents include onium salts (excluding sulfonium salts), triazine compounds having a trihalomethyl group, peroxides, azo-type polymerization initiators, azide compounds, quinone diazide, oxime ester compounds and triaryl monoalkyl borate compounds. Among these compounds, the onium salts are highly sensitive and preferably used.

Examples of the onium salts which can be used preferably in the present invention include iodonium salts and diazonium salts. In the present invention, these onium salts function not as acid generating agents but as radical polymerization initiators.

The onium salts used preferably in the present invention are onium salts represented by the following general formulae (II) and (III).

General formula (II) Ar²¹-|⁺-A r²² Z²¹⁻

General formula (III) Ar³¹-N⁺≡N Z³¹⁻

In the general formula (II), Ar²¹ and Ar²² each independently represent an aryl group having 20 or less carbon atoms, which may have a substituent group. When this aryl group has a substituent group, the substituent group is preferably a halogen atom, a nitro group, an alkyl group having 12 or less carbon atoms, an alkoxy group having 12 or less carbon atoms, or an aryloxy group having 12 or less carbon atoms. Z²¹⁻ represents a counterion having the same meaning as defined for Z¹¹⁻.

In the general formula (III), Ar³¹ represents an aryl group having 20 or less carbon atoms, which may have a substituent group. The substituent group is preferably a halogen atom, a nitro group, an alkyl group having 12 or less carbon atoms, an alkoxy group having 12 or less carbon atoms or an aryloxy group having 12 or less carbon atoms, an alkylamino group having 12 or less carbon atoms, a dialkylamino group having 12 carbon atoms, an arylamino group having 12 or less carbon atoms, or a diarylamino group having 12 or less carbon atoms. Z³¹⁻ represents a counterion having the same meaning as defined for Z¹¹⁻.

Preferable examples of the iodonium salts ([OI-1] to [OI-10]) represented by the general formula (II) and the diazonium salts ([ON-1] to [ON-5]) represented by the general formula (III) are mentioned below, but the onium salts are not limited thereto.

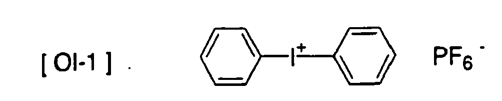

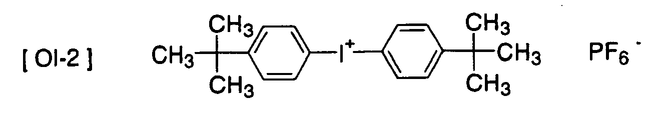

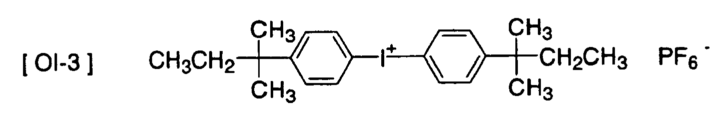

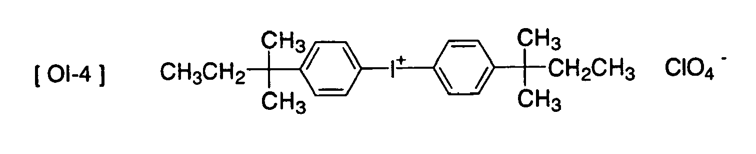

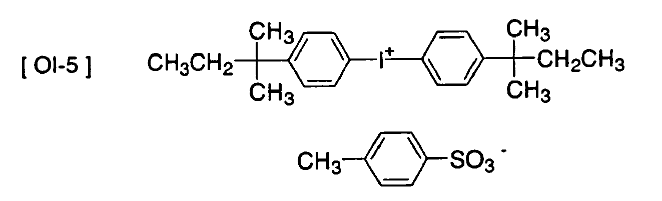

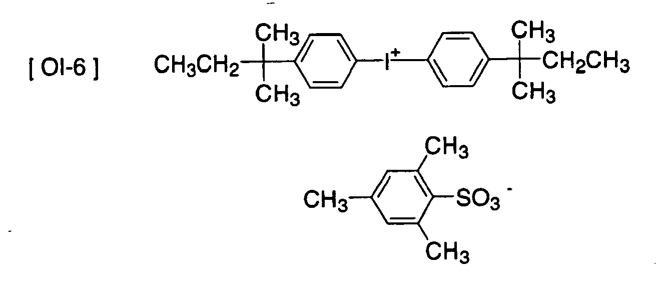

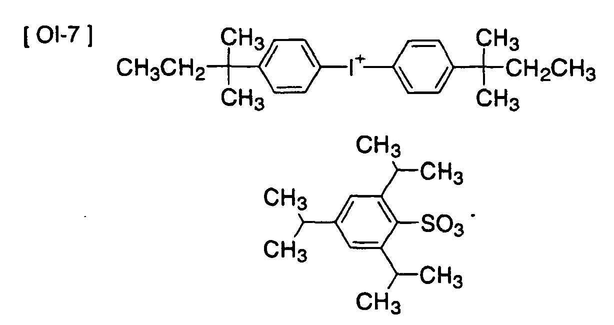

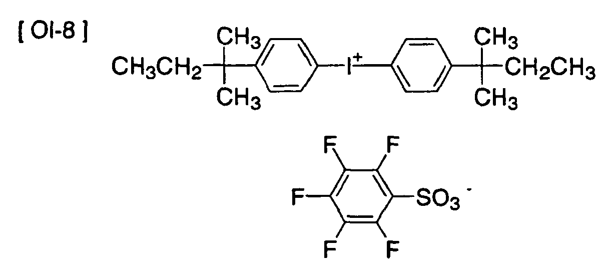

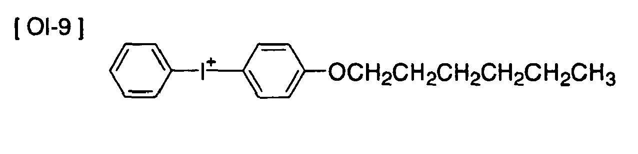

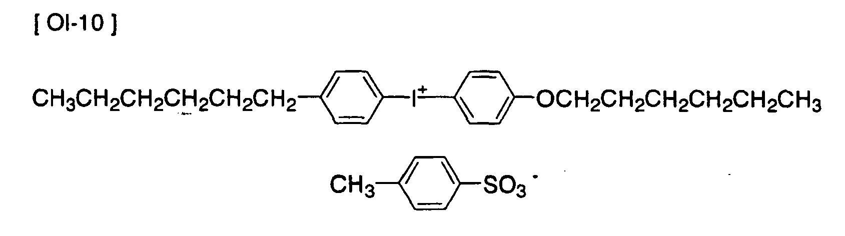

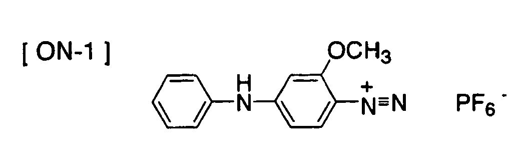

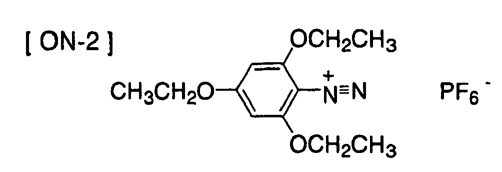

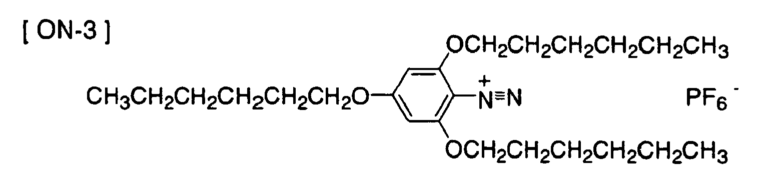

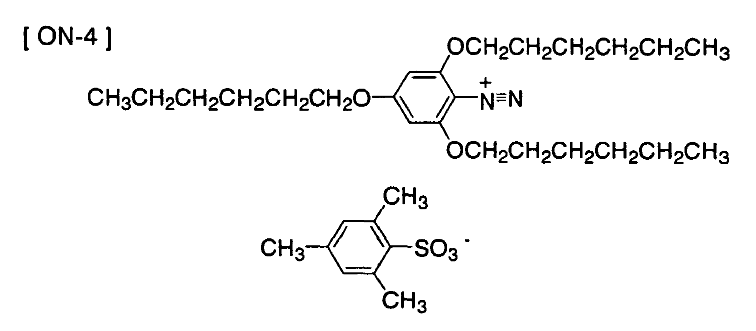

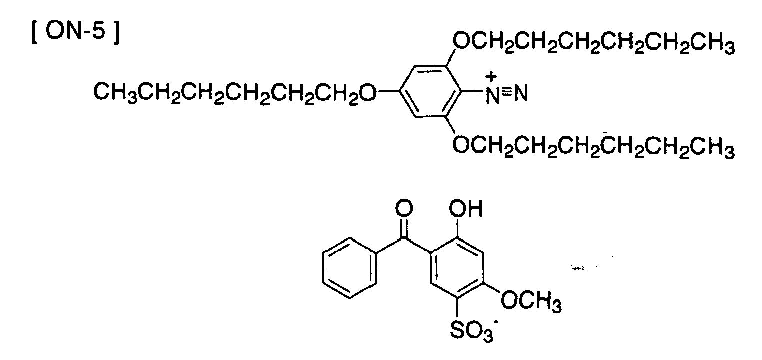

In the present invention, examples of the onium salts preferably used as the polymerization initiator (radical generating agent) include those described in JP-A No. 2001-133696.

The polymerization initiator (radical-generating agent) used in the present invention has a maximum absorption wavelength of preferably 400 nm or less, more preferably 360 nm or less. By using the radical-generating agent having its absorption wavelength in the UV range, the planographic printing plate precursor can be handled under an incandescent lamp.

From the viewpoint of sensitivity and the generation of smudging in a non-image at the time of printing, the total content of the polymerization initiator in the photosensitive composition of the present invention is 0.1 to 50% by mass, and preferably 0.5 to 30% by mass, more preferably 1 to 20% by mass, based on the solid content of the photosensitive composition.

In the present invention, only one polymerization initiator or two or more polymerization initiators may be used insofar a sulfonium salt polymerization initiator is contained as the essential component. When two or more polymerization initiators are used in combination, a plurality of sulfonium salt polymerization initiators can be used, or the sulfonium salt polymerization initiator can be used in combination with another polymerization initiator.

When the sulfonium salt polymerization initiator is used in combination with other polymerization initiator, the ratio (ratio by mass) of the sulfonium salt polymerization initiator to the other polymerization initiator is preferably 100/1 to 100/50, more preferably 100/5 to 100/25.

When the photosensitive composition of the present invention is applied to a planographic printing plate precursor, the polymerization initiator, along with other components, may be added to the same layer or to a separately provided layer.

### (Binder polymer)

From the viewpoint of improving layer-forming properties, the photosensitive layer in the present invention preferably comprises a binder polymer, particularly preferably a binder polymer having a repeating unit represented by the following general formula (i).

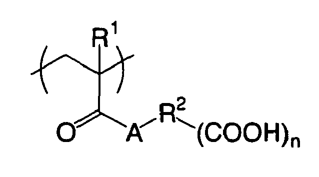

In the general formula (i), R¹ represents a hydrogen atom or a methyl group; R² represents a linking group composed of two or more atoms selected from the group consisting of a carbon atom, a hydrogen atom, an oxygen atom, a nitrogen atom and a sulfur atom, and wherein the total number of atoms in R² is 2 to 82; A represents an oxygen atom or -NR³- in which R³ represents a hydrogen atom or a monovalent hydrocarbon group having 1 to 10 carbon atoms; and n is an integer from 1 to 5.

The binder polymer having a repeating unit represented by the general formula (i) is also referred to as "specific binder polymer" and described in more detail below.

R¹ in the general formula (I) represents a hydrogen atom or a methyl group, preferably a methyl group.

The linking group represented by R² in the general formula (i) is a linking group composed of two or more atoms selected from the group consisting of a carbon atom, a hydrogen atom, an oxygen atom, a nitrogen atom and a sulfur atom, and wherein the total number of atoms in R² is 2 to 82, preferably 2 to 50, and more preferably 2 to 30. The number of atoms refers to the number of atoms including atoms in a substituent group, if any, on the linking group.

Specifically, the number of carbon atoms in the main skeleton of the linking group represented by R² is preferably 1 to 30, more preferably 3 to 25, still more preferably 4 to 20, and most preferably 5 to 10. The "main skeleton of the linking group" in the present invention refers to an atom or an atomic group used in linking A to the terminal COOH in the general formula (i), and when a plurality of linkages are present, the main skeleton refers to an atom or an atomic group constituting a linkage having the smallest number of atoms. Accordingly, when the linking group has a cyclic structure, its linking sites (for example, o-, m-, p-, etc.) are different in the number of atoms to be introduced into them.

The linking group represented by R² is more specifically an alkylene group, a substituted alkylene group, an arylene group and a substituted arylene, and these divalent groups may be in a chain structure bound to one another via amide or ester linkages. Linking groups in the chain structure include ethylene, propylene, etc. A structure comprising these alkylene groups bound to one another via ester linkages is also preferable.

The linking group represented by R² in formula (i) is preferably a (n+1)-valet hydrocarbon group having an alicyclic structure having 3 to 30 carbon atoms. Examples thereof include (n+1)-valent hydrocarbon groups obtained by removing (n+1) hydrogen atoms on arbitrary carbon atoms constituting compounds having an alicyclic structure, such as cyclopropane, cyclopentane, cyclohexane, cycloheptane, cyclooctane, cyclodecane, dicyclohexyl, tertiary cyclohexyl and norbornane which may be substituted with one or more arbitrary substituent groups. R² is preferably the one containing 3 to 30 carbon atoms including carbon atoms in a substituent group if any.

The arbitrary carbon atoms in a compound constituting an alicyclic structure may be substituted with one or more heteroatoms selected from the group consisting of a nitrogen atom, an oxygen atom and a sulfur atom. In terms of printing durability, R² is preferably a (n+1)-valent hydrocarbon group having an alicyclic structure which may have a substituent group having 5 to 30 carbon atoms comprising two or more rings, such as a condensed polycyclic aliphatic hydrocarbon, a crosslinked alicyclic hydrocarbon, spiroaliphatic hydrocarbon, and combined aliphatic hydrocarbon rings (plural rings combined directly or via linking groups). The number of carbon atoms refers to the number of carbon atoms including carbon atoms in a substituent group, if any.

The linking group represented by R² is preferably a group containing 5 to 10 atoms, having a cyclic structure containing an ester linkage or the cyclic structure described above.

A substituent group which can be introduced into the linking group represented by R² includes a monovalent non-metal atomic group excluding hydrogen, and examples thereof include a halogen atom (-F, -Br, -Cl, -I), hydroxyl group, alkoxy group, aryloxy group, mercapto group, alkyl thio group, aryl thio group, alkyl dithio group, aryl dithio group, amino group, N-alkyl amino group, N,N-dialkyl amino group, N-aryl amino group, N,N-diaryl amino group, N-alkyl-N-aryl amino group, acyloxy group, carbamoyloxy group, N-alkylcarbamoyloxy group, N-aryl carbamoyloxy group, N,N-dialkyl carbamoyloxy group, N,N-diaryl carbamoyloxy group, N-alkyl-N-aryl carbamoyloxy group, alkyl sulfoxy group, aryl sulfoxy group, acyl thio group, acyl amino group, N-alkyl acyl amino group, N-aryl acyl amino group, ureido group, N'-alkyl ureido group, N',N'-dialkyl ureido group, N'-aryl ureido group, N',N'-diaryl ureido group, N'-alkyl-N'-aryl ureido group, N-alkyl ureido group, N-aryl ureido group, N'-alkyl-N-alkyl ureido group, N'-alkyl-N-aryl ureido group, N',N'-dialkyl-N-alkyl ureido group, N',N'-dialkyl-N-aryl ureido group, N'-aryl-N-alkyl ureido group, N'-aryl-N-aryl ureido group, N',N'-diaryl-N-alkyl ureido group, N',N'-diaryl-N-aryl ureido group, N'-alkyl-N'-aryl-N-alkyl ureido group, N'-alkyl-N'-aryl-N-aryl ureido group, alkoxy carbonyl amino group, aryloxy carbonyl amino group, N-alkyl-N-alkoxycarbonyl amino group, N-alkyl-N-aryloxy carbonyl amino group, N-aryl-N-alkoxycarbonyl amino group, N-aryl-N-aryloxycarbonyl amino group, formyl group, acyl group, carboxyl group and its conjugated basic group, alkoxy carbonyl group, aryloxy carbonyl group, carbamoyl group, N-alkyl carbamoyl group, N,N-dialkyl carbamoyl group, N-aryl carbamoyl group, N,N-diaryl carbamoyl group, N-alkyl-N-aryl carbamoyl group, alkyl sulfinyl group, aryl sulfinyl group, alkyl sulfonyl group, aryl sulfonyl group, sulfo group (-SO₃H) and its conjugated basic group, alkoxy sulfonyl group, aryloxy sulfonyl group, sulfinamoyl group, N-alkyl sulfinamoyl group, N,N-dialkyl sulfinamoyl group, N-aryl sulfinamoyl group, N,N-diaryl sulfinamoyl group, N-alkyl-N-aryl sulfinamoyl group, sulfamoyl group, N-alkyl sulfamoyl group, N,N-dialkyl sulfamoyl group, N-aryl sulfamoyl group, N,N-diaryl sulfamoyl group, N-alkyl-N-aryl sulfamoyl group, N-acyl sulfamoyl group and its conjugated basic group, N-alkyl sulfonyl sulfamoyl group (-SO₂NHSO₂ (alkyl)) and its conjugated basic group, N-aryl sulfonyl sulfamoyl group (-SO₂NHSO₂(aryl)) and its conjugated basic group, N-alkyl sulfonyl carbamoyl group (-CONHSO₂(alkyl)) and its conjugated basic group, N-aryl sulfonyl carbamoyl group (-CONHSO₂(aryl)) and its conjugated basic group, alkoxy silyl group (-Si(O-alkyl)₃), aryloxy silyl group (-Si(O-aryl)₃), hydroxylyl group (-Si(OH)₃) and its conjugated basic group, pohsphono group (-PO₃H₂) and its conjugated basic group, dialkyl phosphono group (-PO₃(alkyl)₂), diaryl phosphono group (-PO₃(aryl)₂), alkyl aryl phosphono group (-PO₃(alkyl)(aryl)), monoalkyl phosphono group (-PO₃H(alkyl)) and its conjugated basic group, monoaryl phosphono group (-PO₃H(aryl)) and its conjugated basic group, phosphonoxy group (-OPO₃H₂) and its conjugated basic group, dialkyl phosphonoxy group (-OPO₃(alkyl)₂), diaryl phosphonoxy group (-OPO₃(aryl)₂), alkyl aryl phosphonoxy group (-OPO₃(alkyl)(aryl)), monoalkyl phosphonoxy group (-OPO₃H(alkyl)) and its conjugated basic group, monoaryl phosphonoxy group (-OPO₃H(aryl)) and its conjugated basic group, cyano group, nitro group, dialkyl boryl group (-B(alkyl)₂), diaryl boryl group (-B(aryl)₂), alkyl aryl boryl group (-B(alkyl)(aryl)), dihydroxy boryl group (-B(OH)₂) and its conjugated basic group, alkyl hydroxy boryl group (-B(alkyl)(OH)) and its conjugated basic group, aryl hydroxy boryl group (-B(aryl)(OH)) and its conjugated basic group, aryl group, alkenyl group and alkynyl group.

When the photosensitive composition of the present invention is applied to the planographic printing plate precursor, depending on the design of the photosensitive layer, a substituent group having a hydrogen atom capable of hydrogen bonding, particularly a substituent group having acidity whose acid dissociation constant (pKa) is lower than that of carboxylic acid, is not preferable because it tends to deteriorate printing durability. On the other hand, a hydrophobic substituent group such as a halogen atom, a hydrocarbon group (alkyl group, aryl group, alkenyl group, alkynyl group), an alkoxy group and an aryloxy group is preferable because it tends to improve printing durability, and particularly when the cyclic structure is a 6- or less memberred monocyclic aliphatic hydrocarbon such as cyclopentane or cyclohexane, the hydrocarbon preferably has such hydrophobic substituent groups. If possible, these substituent groups may be bound to one another or to a substituted hydrocarbon group to form a ring, and the substituent groups may further be substituted.

When A in formula (i) is NR³-, R³ represents a hydrogen atom or a monovalent hydrocarbon group having 1 to 10 carbon atoms. The monovalent hydrocarbon group having 1 to 10 carbon atoms represented by R³ includes an alkyl group, aryl group, alkenyl group and alkynyl group.

Examples of the alkyl group having 1 to 10 carbon atoms include a linear, branched or cyclic alkyl group such as a methyl group, ethyl group, propyl group, butyl group, pentyl group, hexyl group, heptyl group, octyl group, nonyl group, decyl group, isopropyl group, isobutyl group, sec-butyl group, tert-butyl group, isopentyl group, neopentyl group, 1-methylbutyl group, isohexyl group, 2-ethylhexyl group, 2-methylhexyl group, cyclopentyl group, cyclohexyl group, 1-adamanthyl group and 2-norbornyl group.

Examples of the aryl group having 1 to 10 carbon atoms include an aryl group such as a phenyl group, naphthyl group and indenyl group, a heteroaryl group having 1 to 10 carbon atoms containing one heteroatom selected from the group consisting of a nitrogen atom, an oxygen atom and a sulfur atom, for example a furyl group, thienyl group, pyrrolyl group, pyridyl group and quinolyl group.

Examples of the alkenyl group having 1 to 10 carbon atoms include a linear, branched or cyclic alkenyl group such as a vinyl group, 1-propenyl group, 1-butenyl group, 1-methyl-1-propenyl group, 1-cyclopentenyl group and 1-cyclohexenyl group.

Examples of the alkynyl group include an alkynyl group having 1 to 10 carbon atoms such as an ethynyl group, 1-propynyl group, 1-butynyl group and 1-octynyl group. Substituent groups which may be possessed by R³ include the same substituent groups as those capable of being introduced into R². The number of carbon atoms in R³, including the number of carbon atoms in its substituent group, is 1 to 10.

A in the general formula (i) is preferably an oxygen atom or -NH- because of easy synthesis.

n in the general formula (i) is an integer from 1 to 5, preferably 1 in view of printing durability.

Preferable examples of the repeating unit represented by the general formula (i) in the specific binder polymer are shown below, but the present invention is not limited thereto.

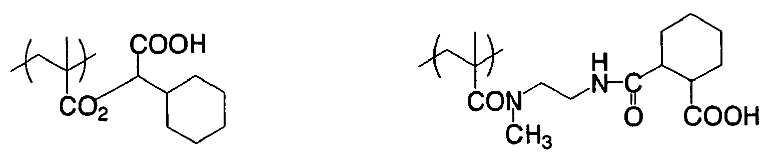

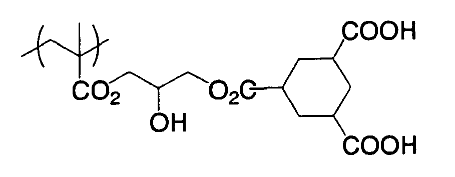

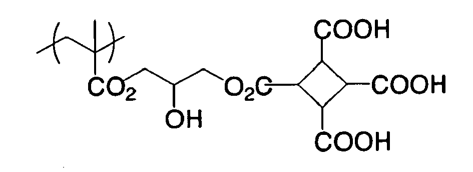

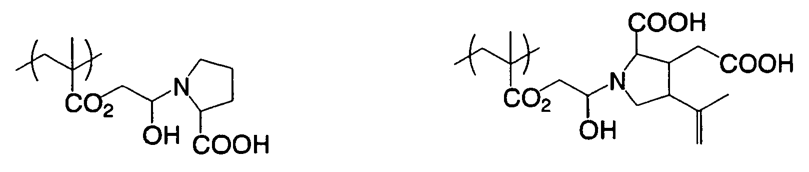

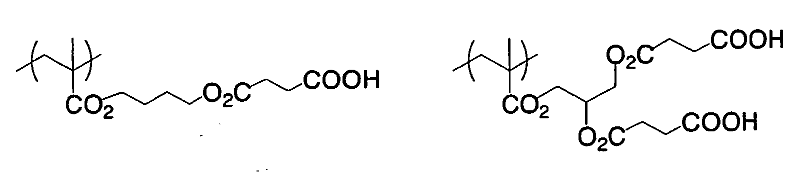

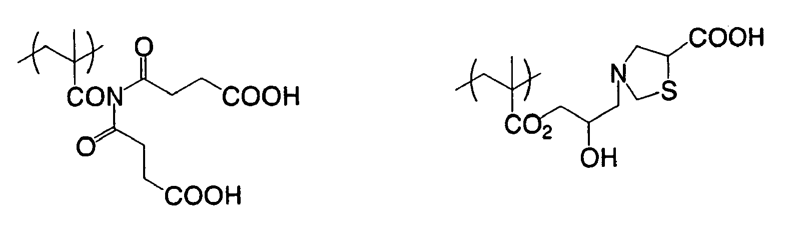

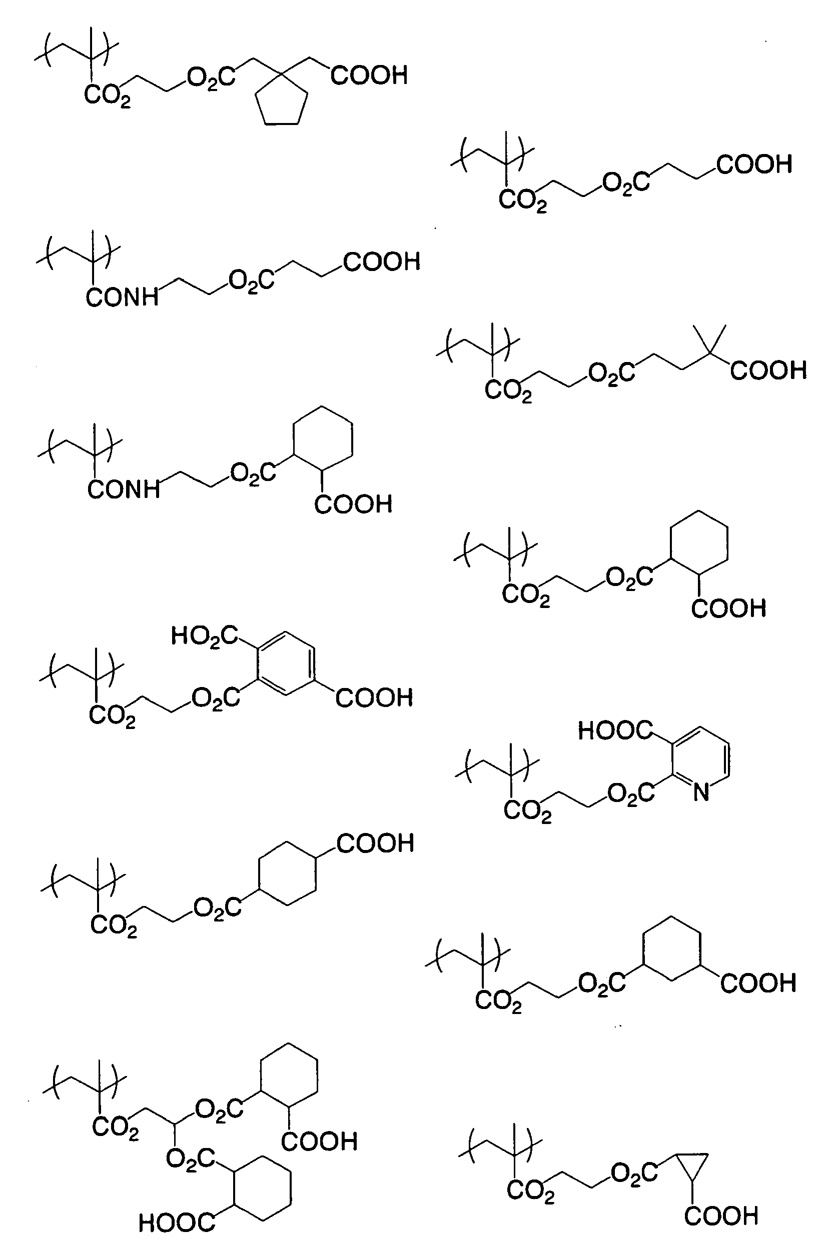

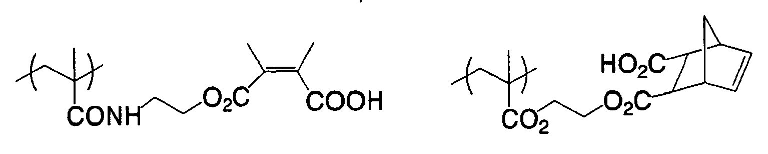

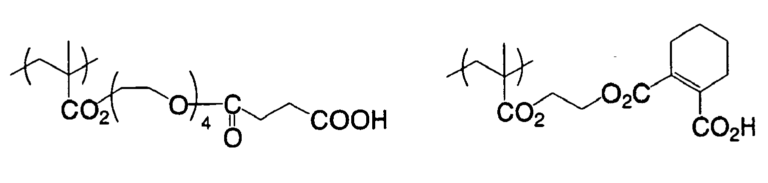

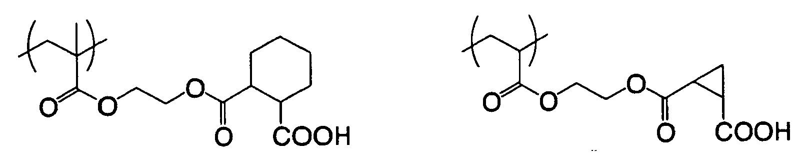

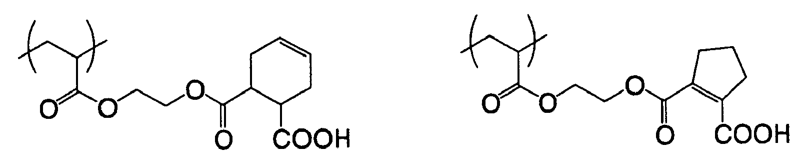

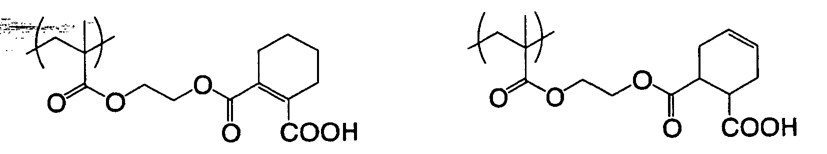

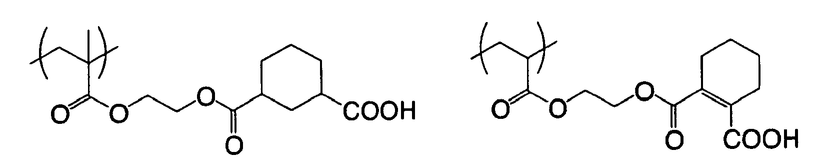

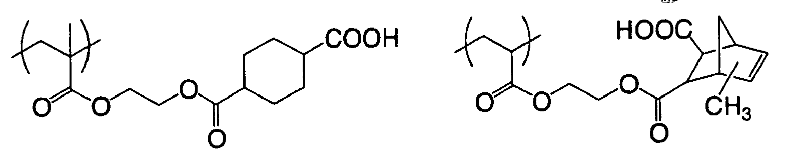

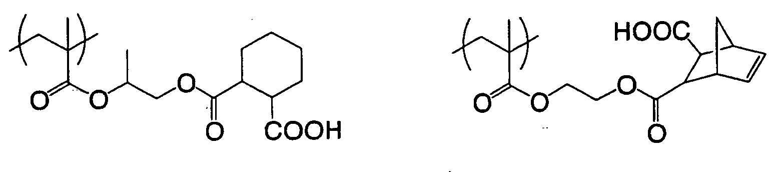

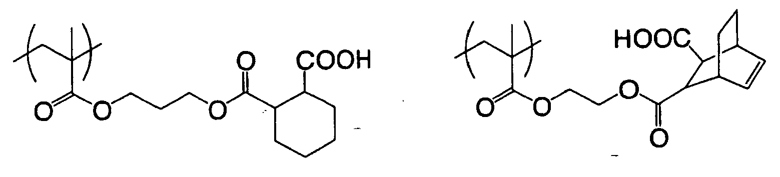

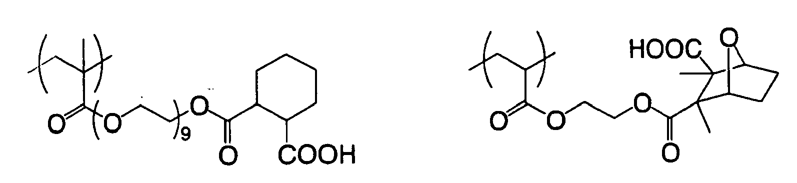

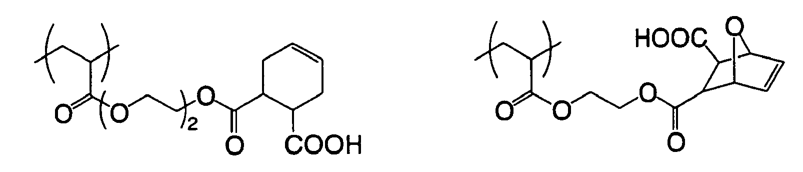

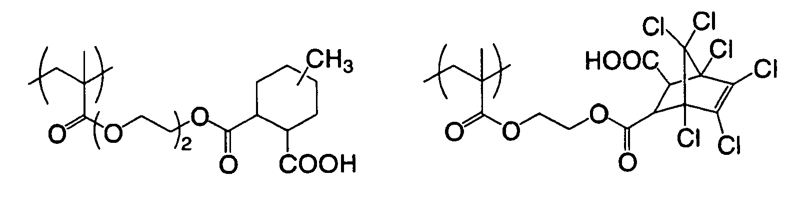

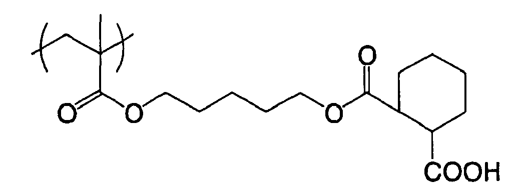

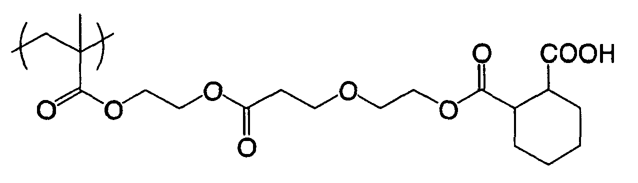

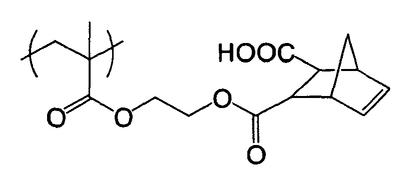

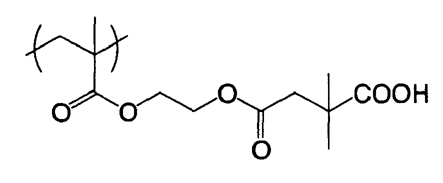

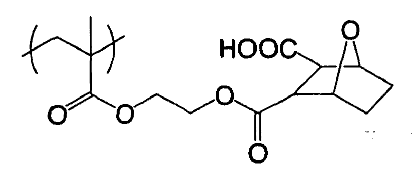

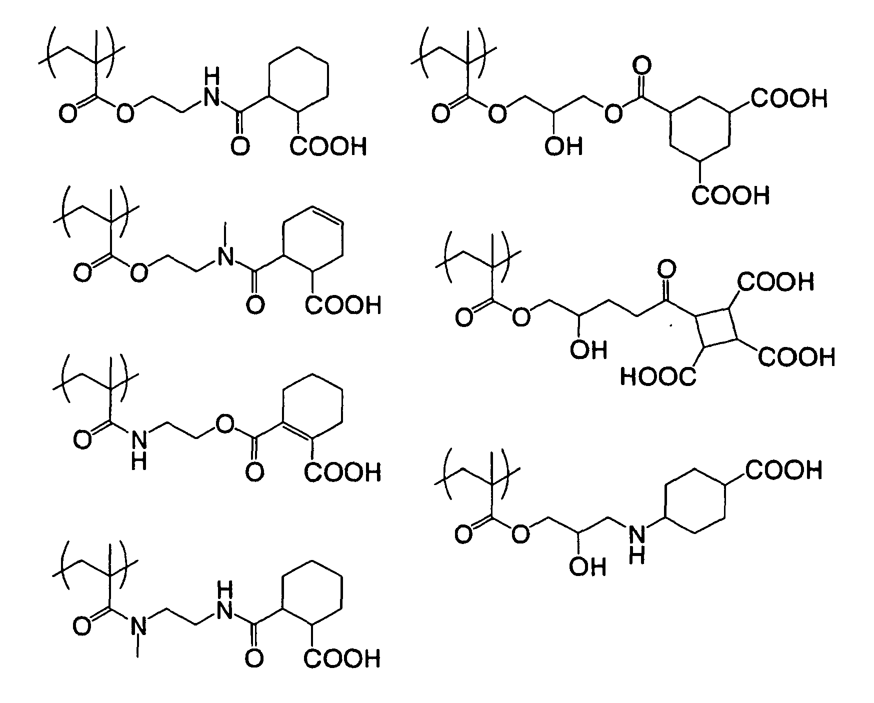

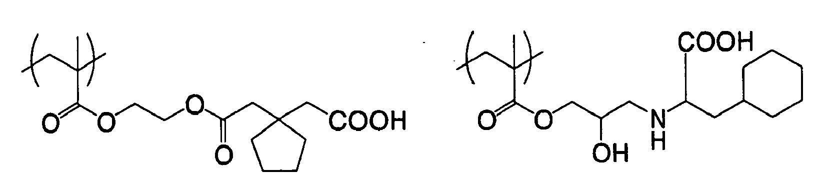

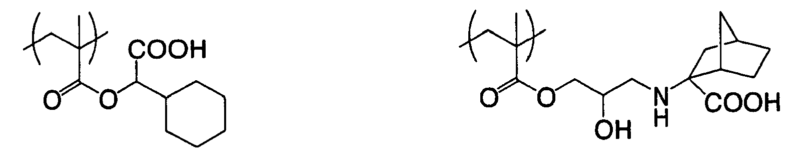

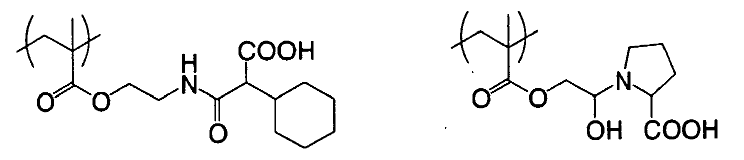

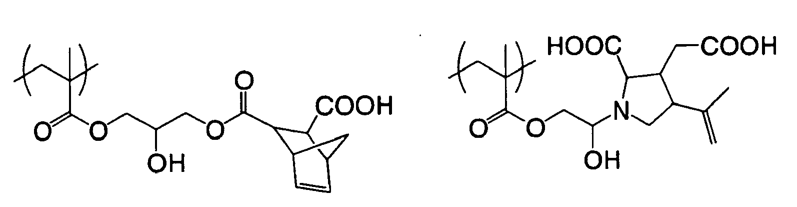

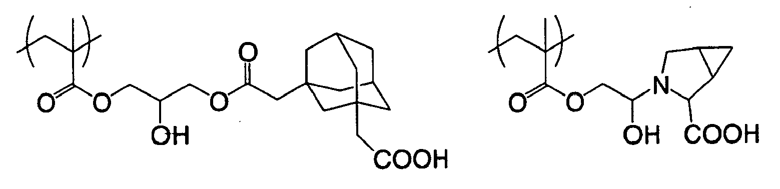

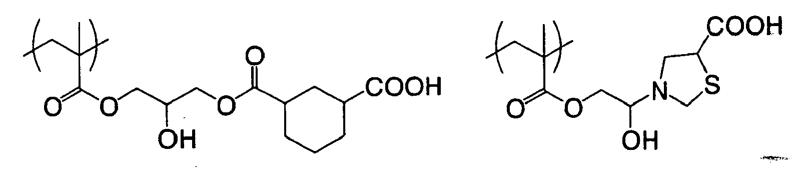

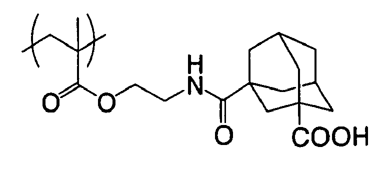

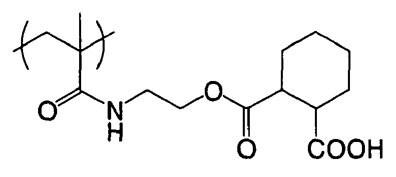

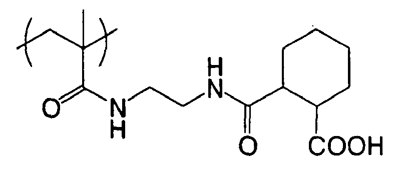

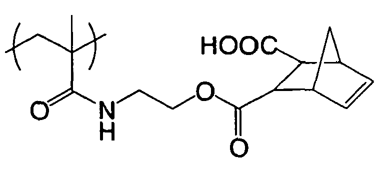

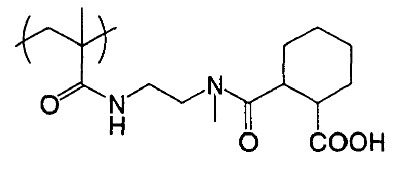

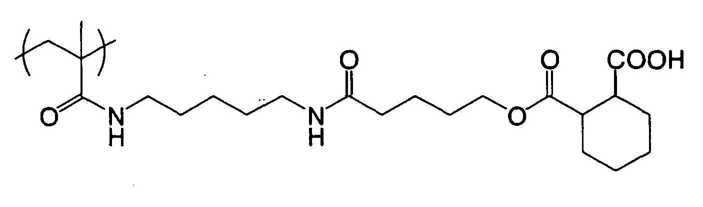

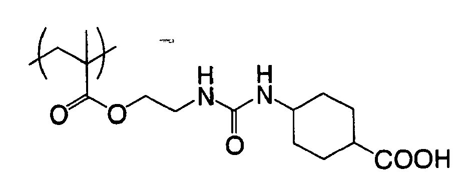

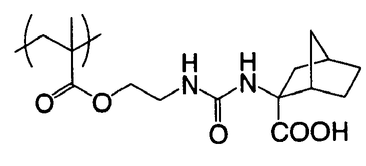

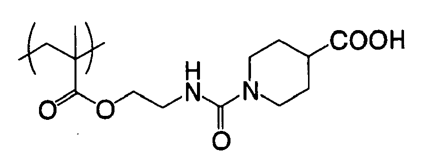

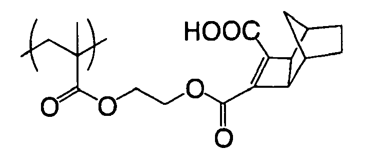

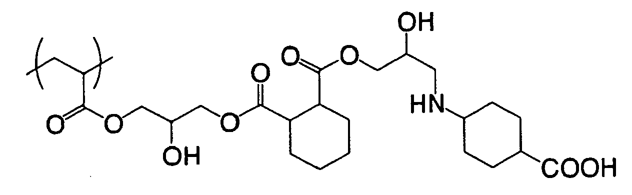

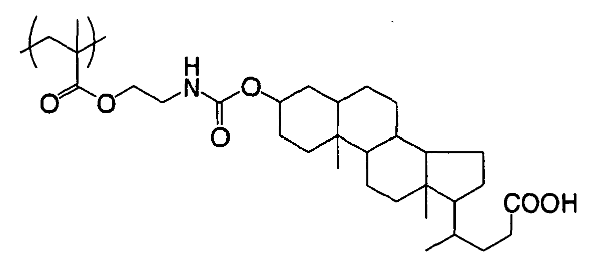

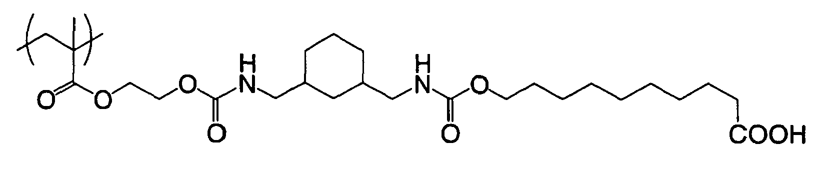

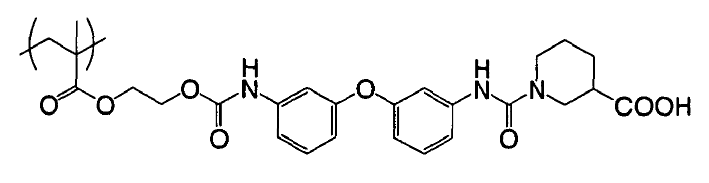

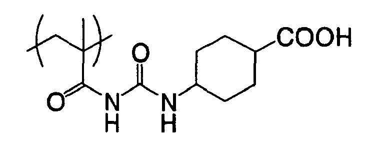

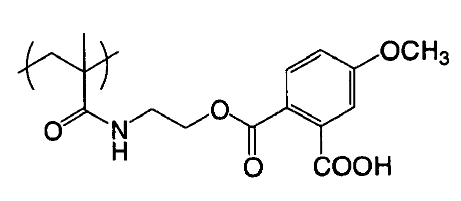

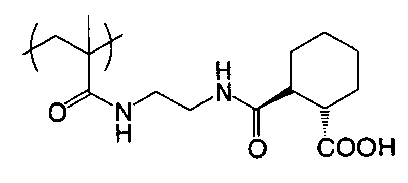

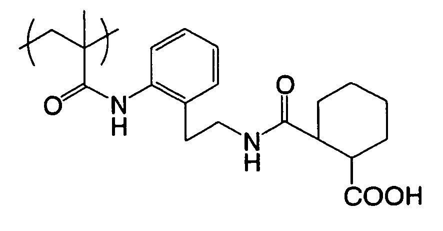

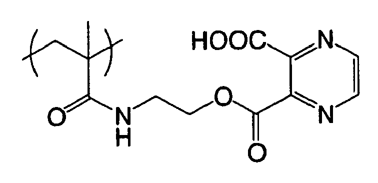

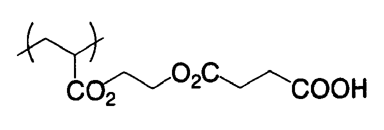

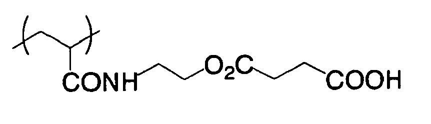

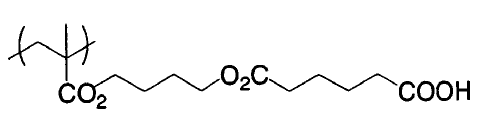

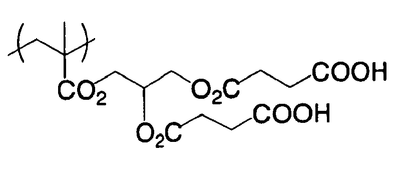

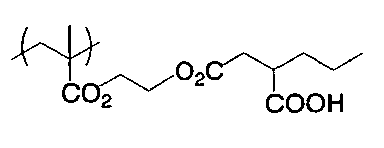

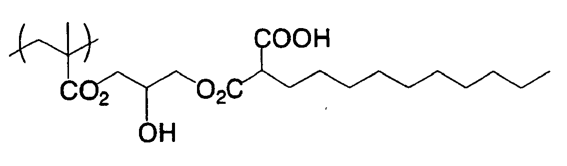

One or two or more kinds of repeating unit represented by the general formula (i) may be contained in the binder polymer. The specific binder polymer in the present invention may be a polymer composed exclusively of the repeating unit represented by the general formula (i), but is usually used as a copolymer containing other copolymerizable components. The total content of the repeating unit represented by the general formula (i) in the copolymer is suitably determined depending on the structure of the copolymer, design of the photosensitive layer, etc., but usually the repeating unit is contained in an amount of 1 to 99% by mole, more preferably 5 to 40% by mole, and still more preferably 5 to 20% by mole, based on the total molar amount of the polymer components.

When a copolymer is used as the binder polymer, copolymerizable components known in the art can be used without limitation insofar as they are radical-polymerizable monomers. Specifically, monomers described in the *Polymer Data Handbook -Fundamental Version-* compiled by the Society of Polymer Science, Japan and published by Baifukan, 1986 are exemplified. Such copolymerizable components can be used alone or in combination.

The molecular weight of the specific binder polymer in the present invention is suitably determined from the viewpoint of image-forming property and printing durability. Usually, when the molecular weight is increased, printing durability is improved but the image-forming property tends to be deteriorated. On the other hand, when the molecular weight is decreased, the image-forming property is improved, while printing durability is deteriorated. The molecular weight is preferably in the range of 2,000 to 1,000,000, more preferably 5,000 to 500,000, and still more preferably 10,000 to 200,000.

As the binder polymer used in the photosensitive layer in the present invention, the specific binder polymer may be used alone, or may be used in combination with one or more other binder polymers. When the specific binder is used, binder polymers used in combination therewith are used in the range of 1 to 60% by mass, preferably 1 to 40% by mass, and more preferably 1 to 20% by mass, based on the total weight of the binder polymer components. As the binder polymer, any known binder polymers can be used without limitation, and specifically an acrylic main-chain binder and a urethane binder used often in this field are preferably used.

The total amount of the specific binder polymer and binder polymers which can be used in combination therewith in the composition can be suitably determined, and is usually 10 to 90% by mass, preferably 20 to 80% by mass, and more preferably 30 to 70% by mass, based on the total weight of nonvolatile components in the composition.

The acid value (meg/ g) of the binder polymer is preferably in the range of 2.00 to 3.60.

### (Other binder polymers usable in combination)

The binder polymer which can be used in combination with the specific binder polymer is preferably a binder polymer having a radical-polymerizable group. The radical-polymerizable group is not particularly limited insofar as it can be polymerized with a radical, and examples thereof include α-substituted methyl acryl group [-OC(=O)-C(-CH₂Z)=CH₂ wherein Z is a hydrocarbon group starting from a heteroatom], acryl group, methacryl group, allyl group and styryl group, among which an acryl group and methacryl group are preferable.

The content of the radical-polymerizable group in the binder polymer (content of radical-polymerizable unsaturated double bonds determined by iodine titration) is preferably 0.1 to 10.0 mmol, more preferably 1.0 to 7.0 mmol, and most preferably 2.0 to 5.5 mmol, per g of the binder polymer. When this content is lower than 0.1 mmol, the curing properties may be deteriorated to be less sensitive. When the content is higher than 10.0 mmol, stability may be lost and shelf stability may deteriorate.

Preferably, the binder polymer further has an alkali-soluble group. The content of the alkali-soluble group (acid value determined by neutralization titration) in the binder polymer is preferably 0.1 to 3.0 mmol, more preferably 0.2 to 2.0 mmol, and most preferably 0.45 to 1.0 mmol, per g of the binder polymer. When the content is lower than 0.1 mmol, the binder polymer may be precipitated during development to generate development scum. When the content is higher than 3.0 mmol, the hydrophilicity of the binder polymer may be too high, thus deteriorating printing durability.

The weight-average molecular weight of the binder polymer is in the range of preferably 2,000 to 1,000,000, more preferably 10,000 to 300,000, and most preferably 20,000 to 200,000. When the weight-average molecular weight is less than 2,000, the layer-forming property may be lowered to deteriorate printing durability. When the weight-average molecular weight is greater than 1,000,000, it may be difficult to dissolve the binder polymer in a coating solvent, thus lowering the coating property.

The glass transition point (Tg) of the binder polymer is in the range of preferably 70° to 300°C, more preferably 80° to 250°C, and most preferably 90° to 200°C. When the glass transition point is lower than 70°C, storability may become poor, thus deteriorating printing durability. When the glass transition point is higher than 300°C, the mobility of radicals in the photosensitive layer may be lowered, thus making sensitivity low.

As a means of increasing the glass transition point of the binder polymer, its molecule preferably contains an amide group or imide group, and particularly preferably contains methacrylamide derivatives.

In addition to the fundamental components described above, other components suitable for uses, process, etc., can be added to the photosensitive composition of the present invention. Hereinafter, preferable additives are mentioned.

### (Polymerization inhibitor)

A small amount of a heat-polymerization inhibitor is preferably added to the photosensitive composition of the present invention in order to inhibit undesired heat polymerization of the polymerizable compound having an ethylenically unsaturated bond. Preferable examples of the heat-polymerization inhibitor include hydroquinone, p-methoxyphenol, di-t-butyl-p-cresol, pyrogallol, t-butyl catechol, benzoquinone, 4,4'-thiobis(3-methyl-6-t-butyl phenol), 2,2'-methylene bis(4-methyl-6-t-butyl phenol), N-nitrosophenyl hydroxylamine primary cerium salts, etc. The amount of the heat-polymerization inhibitor added is preferably about 0.01 to about 5% by mass relative to the weight of nonvolatile components in the entire composition. To prevent the inhibition of polymerization by oxygen, a higher fatty acid derivative such as behenic acid or behenic amide may be added as necessary so that it is allowed to be locally present on the surface of the photosensitive layer in the drying step after application. The amount of the higher fatty acid derivative added is preferably about 0.5 to about 10% by mass relative to nonvolatile components in the entire composition.

### (Coloring agent)

Dyes or pigments may be added to the photosensitive composition of the present invention for the purpose of coloring. The plate-checking property, that is, the visibility of the printing plate after plate-making and the applicability for image densitometer can thereby be improved when the composition is applied to the printing plate. When dyes are used as the coloring agent, many of these can cause a reduction in the sensitivity of the photo-polymerizable photosensitive layer, and thus, it is particularly preferable to use pigments as the coloring agent. Examples of the coloring agent include pigments such as phthalocyanine type pigments, azo type pigments, carbon black and titanium oxide, and dyes such as ethyl violet, crystal violet, azo type dyes, anthraquinone type dyes and cyanine type dyes. The amount of the dyes and pigments added is preferably about 0.5 to about 5% by mass of nonvolatile components in the entire composition.

### (Other additives)

Known additives such as inorganic fillers for improving the physical properties of the cured layer, as well as other plasticizers and sensitizers for improving inking properties on the surface of the photosensitive layer may also be added. The plasticizers include dioctyl phthalate, didodecyl phthalate, triethylene glycol dicaprylate, dimethyl glycol phthalate, tricresyl phosphate, dioctyl adipate, dibutyl sebacate, triacetyl glycerin, etc., and these can be added in an amount of 10% by mass or less relative to the total weight of the binder polymer and the addition-polymerizable compound. UV initiators and heat-crosslinking agents for enhancing the effect of heating and irradiation after development can also be added for the purpose of improving the layer strength (printing durability) described later.

The photosensitive composition of the present invention can be applied preferably as a photosensitive layer in the planographic printing plate precursor of the present invention described below.

### [Planographic printing plate precursor]

The planographic printing plate precursor in the present invention is a planographic printing plate precursor comprising a photosensitive layer disposed on a substrate, wherein the photosensitive layer including the photosensitive composition of the present invention. The planographic printing plate precursor can be prepared by dissolving the photosensitive coating solution containing the photosensitive composition of the present invention and a coating component for desired layers such as a protective layer in a solvent and coating the solution onto a suitable substrate or an intermediate layer.

### [Photosensitive layer]

The photosensitive layer in the present invention is a thermal-polymerizable negative photosensitive layer comprising an infrared absorbing agent, a sulfonium salt polymerization initiator, a polymerizable compound (also referred to as addition-polymerizable compound), and a binder as essential components. The thermal polymerizable negative photographic layer has a mechanism wherein the polymerization initiator is decomposed with heat to generate radicals causing polymerization reaction of the polymerizable compound. This photosensitive layer is particularly preferably used in plate-making for direct printing with laser light having a wavelength of 300 to 1,200 nm, to exhibit higher printing durability and image-forming property than those of conventional planographic printing plate precursors.

When the photosensitive layer is arranged by coating, the photosensitive composition of the present invention is dissolved in various organic solvents and applied onto the substrate or the intermediate layer. The solvent used includes acetone, methyl ethyl ketone, cyclohexane, ethyl acetate, ethylene dichloride, tetrahydrofuran, toluene, ethylene glycol monomethyl ether, ethylene glycol monoethyl ether, ethylene glycol dimethyl ether, propylene glycol monomethyl ether, propylene glycol monoethyl ether, acetyl acetone, cyclohexanone, diacetone alcohol, ethylene glycol monomethyl ether acetate, ethylene glycol ethyl ether acetate, ethylene glycol monoisopropyl ether, ethylene glycol monobutyl ether acetate, 3-methoxy propanol, methoxy methoxy ethanol, diethylene glycol monomethyl ether, diethylene glycol monoethyl ether, diethylene glycol dimethyl ether, diethylene glycol diethyl ether, propylene glycol monomethyl ether acetate, propylene glycol monoethyl ether acetate, 3-methoxy propyl acetate, N,N-dimethyl formamide, dimethyl sulfoxide, γ-butyrolactone, methyl lactate and ethyl lactate. These solvents can be used singly or in combination. The solid content of the coating solution is suitably 2 to 50% by mass.

The coating amount of the photosensitive layer mainly affects the sensitivity and developability of the photosensitive layer and the strength and printing durability of the layer exposed to light, and is desirably selected depending on the use. When the coating amount is too low, the printing durability is not sufficient. It is not preferable for the coating amount to be too high because sensitivity is reduced, light exposure requires more time, and a longer time is necessary for development processing. The coating amount on the planographic printing plate precursor for scanning light exposure as the major object of the present invention is preferably in the range of about 0.1 to 10 g/m², and more preferably 0.5 to 5 g/m², in terms of dried weight.

The physical properties of the photosensitive layer in the present invention are preferably that the development rate of the light-unexposed region with an alkali developing solution at pH 10 to 13.5 is not less than 80 nm/sec., and the permeation rate of the alkali developing solution into the light-exposed region is not higher than 100 nF/sec.

The development rate with an alkali developing solution at pH 10 to 13.5 is a value obtained by dividing the thickness (nm) of the photosensitive layer by time (sec) necessary for development, and the permeation rate of the alkali developing solution is a value indicative of a rate of change, upon dipping in a developing solution, in the electrostatic capacity (F) of the photosensitive layer formed on an electroconductive substrate.

Hereinafter, the methods of measuring "the development rate with an alkali developing solution" and "the permeation rate of an alkali developing solution" are described below.

### <Measurement of the development rate with an alkali developing solution>

The development rate of the photosensitive layer with the alkali developing solution is a value obtained by dividing the thickness (nm) of the photosensitive layer by time (sec) necessary for development.

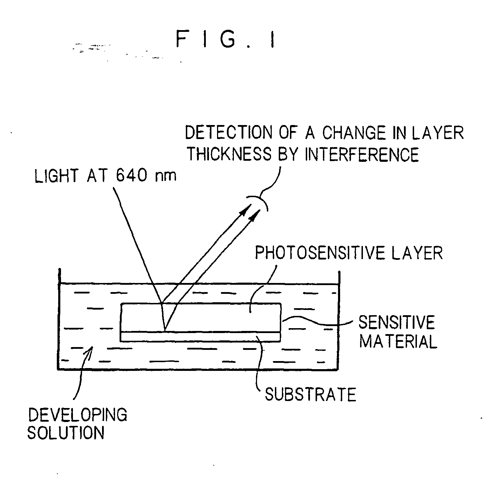

The development rate in the present invention was measured by a DRM interference wave-measuring instrument for measuring the dissolution behavior of a photosensitive layer by dipping an aluminum substrate provided with a light-unexposed photosensitive layer in a predetermined alkali developing solution (30°C) in the range of pH 10 to 13.5, as shown in Fig. 1. Fig. 1 is an illustration of the DRM interference wave-measuring instrument for measuring the dissolution behavior of a photosensitive layer. In the present invention, the change in the layer thickness was detected by interference with a light of 640 nm. When the development behavior is non-swelling development starting from the surface of the photosensitive layer, the layer thickness is gradually decreased in proportion to the development time to give interference waves depending on the thickness. In the case of swelling dissolution (dissolution to remove the layer), the layer thickness is changed depending on the permeation of the developing solution, thus failing to give beautiful interference waves.

The development time (sec) in which the photosensitive layer is completely removed (i.e., the thickness of the layer becomes 0) under these conditions is then determined, and from this development time (sec) and the thickness (nm) of the photosensitive layer, the development rate can be determined from the equation below. A higher development rate indicates easier removal of the layer with the developing solution, that is, good developability.$Development rate \left(of light-unexposed region\right) = \left[( thickness of photosensitive layer \left(nm\right) / development time \left(sec\right)\right]$

### <Measurement of the permeation rate of the alkali developing solution>

The permeation rate of the alkali developing solution is a value indicative of a rate of change, upon dipping in a developing solution, in the electrostatic capacity (F) of the photosensitive layer formed on an electroconductive substrate.

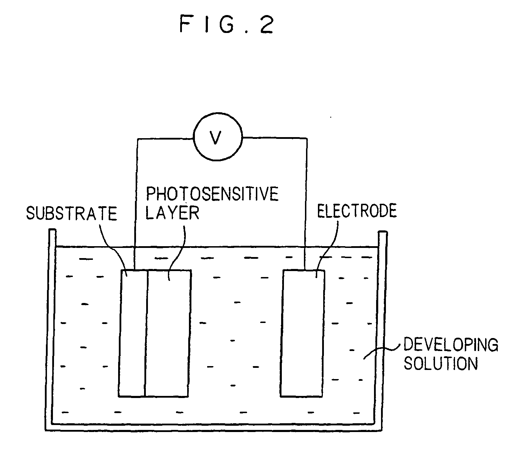

As shown in Fig. 2, the method of measuring electrostatic capacity as an indicator of permeability in the present invention includes a method wherein a cured photosensitive layer on an aluminum substrate used as one electrode and a usual electrode as the other electrode are applied voltage via a conductor wire between the electrodes in a predetermined alkali developing solution (28°C) in the range of pH 10 to 13.5. After applying, the developing solution is permeated into the interface between the substrate and the photosensitive layer, to change the electrostatic capacity in proportion to the dipping time.

From the time (sec) necessary for the change in the electrostatic capacity to become constant and the saturation value (nF) of the electrostatic capacity of the photosensitive layer, the permeation rate can be determined according to the following equation. A smaller permeation rate is indicative of lower permeability of the developing solution.$Rate of permeation of the developing solution \left(into light-exposed region\right) ⁢ \left(nF/sec\right) = \left[saturation value of the electrostatic capacity of the photosensitive layer \left(nF\right)/time \left(sec\right) necessary for the change in electrostatic capacity to become constant\right]$

The properties of the photosensitive layer in the planographic printing plate precursor of the present invention are preferably that the development rate of a light-unexposed region with an alkali developing solution at pH 10 to 13.5 is preferably 80 to 400 nm/ sec., and the rate of permeation of the alkali developing solution into the photosensitive layer is preferably not higher than 90 nF/ sec., as determined by the method described above. The development rate of a light-unexposed region with an alkali developing solution at pH 10 to 13.5 is more preferably 90 to 200 nm/sec., and the rate of permeation of the alkali developing solution into the photosensitive layer is more preferably not higher than 80 nF/sec., as determined by the method described above. The upper limit of the development rate or the lower limit of the permeation rate is not particularly limited, but it is preferable in consideration of the balance between the two rates that the development rate of a light-unexposed region is in the range of 90 to 200 nm/ sec., and the rate of permeation of the alkali developing solution into the photosensitive layer is preferably not higher than 80 nF/ sec.

The rate of development of a light-unexposed region of the photosensitive layer and the rate of permeation of the alkali developing solution into the photosensitive layer after curing can be regulated in a usual manner, and typically, addition of a hydrophilic compound is useful for improvement of the rate of development of the light-unexposed region, and addition of a hydrophobic compound is useful for inhibition of permeation of the developing solution into a light-exposed region.

By using the specific binder polymer in the present invention, the development rate of the photosensitive layer and the permeation rate of the developing solution can be regulated in the preferable ranges described above.

### [Substrate]

As the substrate used in the planographic printing plate precursor of the present invention, a known hydrophilic substrate used in the planographic printing plate precursor can be used without limitation.

The substrate used in the present invention is preferably a dimensionally stable plate, and examples thereof include paper, paper laminated with plastics (e.g., polyethylene, polypropylene, polystyrene, etc.), a metal plate (e.g., aluminum, zinc, copper, etc.) and plastic film (e.g., cellulose diacetate, cellulose triacetate, cellulose propionate, cellulose butyrate, cellulose butyrate acetate, cellulose nitrate, polyethylene terephthalate, polyethylene, polystyrene, polypropylene, polycarbonate, polyvinyl acetal, etc.), and papers or plastic films having these metals laminated or vapor-deposited thereon. The surface of these substrates may be chemically or physically treated, if necessary, in order to imparting hydrophilicity thereto, or enhancing strength thereof.

Particularly, the substrate is preferably a paper, a polyester film or an aluminum plate, among which the aluminum plate is particularly preferable because it is excellent in dimensional stability, is relatively inexpensive, can provide a surface excellent in hydrophilicity and strength by surface treatment conducted as necessary. A composite sheet having an aluminum sheet bonded to a polyethylene terephthalate film, as described in JP-B No. 48-18327, is also preferable.

The aluminum plate is a metal plate based on dimensionally stable aluminum, and is selected not only from a pure aluminum plate but also from an alloy plate based on aluminum containing a very small amount of different elements and a plastic film or paper having aluminum (alloy) laminated or vapor-deposited thereon. In the following description, the substrates made of aluminum or aluminum alloys are referred to collectively as the aluminum substrate. The different elements contained in the aluminum alloy include silicon, iron, manganese, copper, magnesium, chromium, zinc, bismuth, nickel, titanium etc. The content of the different elements in the alloy is up to 10% by mass. Particularly preferable aluminum in the present invention is a pure aluminum plate, but because production of absolutely pure aluminum by refining techniques is difficult, aluminum may contain a very small amount of different elements. The composition of the aluminum plate thus used in the present invention is not limited, and any aluminum plates made of a known and conventionally used aluminum material such as JIS A 1050, JIS A 1100, JIS A 3103 and JIS A 3005 can be used as necessary.

The thickness of the aluminum plate is about 0.1 to 0.6 mm. This thickness can be suitably changed depending on the size of a printing machine, the size of a printing plate, and user's demands. The aluminum plate may or may not be subjected to substrate surface treatment described later.

### (Surface roughening treatment)

The surface roughening treatment includes mechanical roughening, chemical etching and electrolytic grain as disclosed in JP-A No. 56-28893. Use can also be made of an electrochemical surface roughening method for electrochemical surface roughening in a hydrochloric acid or nitric acid electrolyte and mechanical surface roughening methods such as a wire blush grain method of scratching an aluminum surface with a metallic wire, a pole grain method of graining an aluminum surface with abrasive grains ball and an abrasive and a brush grain method of surface roughening with a nylon brush and an abrasive, and these surface roughening methods can be used singly or in combination thereof.. Among these methods, the electrochemical method of chemical surface roughening in a hydrochloric acid or nitric acid electrolyte is particularly useful in surface roughening, and the suitable anodizing electrical quantity is in the range of 50 to 400 C/dm². Specifically, alternating current and/or direct current electrolysis is conducted preferably at a temperature of 20 to 80°C, for 1 second to 30 minutes and at a current density of 100 to 400 C/dm² in an electrolyte containing 0.1 to 50% hydrochloric acid or nitric acid.

The aluminum substrate thus surface-roughened may be etched chemically with an acid or an alkali. Preferable examples of the etching agent include sodium hydroxide, sodium carbonate, sodium aluminate, sodium metasilicate, sodium phosphate, potassium hydroxide, lithium hydroxide etc., and the concentration and temperature are preferably in the range of 1 to 50% and 20 to 100°C, respectively. After etching, washing with an acid is carried out to remove smuts remaining on the surface. The acid used includes nitric acid, sulfuric acid, phosphoric acid, chromic acid, fluoric acid and borofluoric acid. After electrochemical roughening treatment, the method of removing smuts is preferably a method of contacting with 15 to 65% by mass at a temperature of 50 to 90°C as described in JP-A No. 53-12739 and a method of alkali etching as described in JP-B No. 48-28123. After the treatment described above, the method and conditions are not limited insofar as the central line average roughness Ra of the treated surface is 0.2 to 0.5 µm.

### (Anodizing treatment)

The thus treated aluminum substrate having an oxide layer formed thereon is then subjected to anodizing treatment.

In the anodizing treatment, an aqueous solution of sulfuric acid, phosphoric acid, oxalic acid and/or boric acid-sodium borate can be used as a major component in an electrolytic bath. In this case, the electrolyte may contain at least components usually contained in an Al alloy plate, electrode, tap water and underground water. Second and third components may also be contained. The second and third components include, for example, metal ions such as Na, K, Mg, Li, Ca, Ti, Al, V, Cr, Mn, Fe, Co, Ni, Cu and Zn, ammonium ions, and anions such as nitrate ion, carbonate ion, chlorine ion, phosphate ion, fluorine ion, sulfite ion, titanate ion, silicate ion and borate ion, and these may be contained at a concentration of 0 to 10000 ppm. Although the conditions for anodizing treatment are not particularly limited, the plate is treated preferably with 30 to 500 g/L solution at a temperature of 10 to 70°C by direct current or alternating current electrolyte in the range of a current density of 0.1 to 40 A/m². The thickness of the anodized layer formed is in the range of 0.5 to 1.5 µm. Preferably, the thickness is in the range of 0.5 to 1.0 µm. The treatment conditions should be selected such that the pore diameter of micropores present in the anodized layer formed on the substrate by the treatment described above is 5 to 10 nm and the pore density is 8 × 10¹⁵ to 2 × 10¹⁶ pores/m².

For treatment for conferring hydrophilicity on the surface of the substrate, various known methods can be used. The treatment is particularly preferably hydrophilicity-conferring treatment with silicate or polyvinylphosphonic acid. The layer is formed from an Si or P element in an amount of 2 to 40 mg/m², preferably 4 to 30 mg/m². The coating amount can be measured by fluorescence X ray analysis.

In the hydrophilicity-conferring treatment, the aluminum substrate having an anodized layer formed thereon is dipped in an aqueous solution at pH 10 to 13 (determined at 25°C) containing an alkali metal silicate or polyvinylphosphonic acid in an amount of 1 to 30% by mass, more preferably 2 to 15% by mass, for example at 15 to 80°C for 0.5 to 120 seconds.

As the alkali metal silicate used in the hydrophilicization treatment, sodium silicate, potassium silicate, lithium silicate etc. are used. The hydroxide used for raising the pH value of the aqueous alkali metal silicate solution includes sodium hydroxide, potassium hydroxide, lithium hydroxide etc. Alkaline earth metal salts or the group IVB metal salts may be incorporated into the treating solution described above. The alkaline earth metal salts include nitrates such as calcium nitrate, strontium nitrate, magnesium nitrate and barium nitrate, and water-soluble salts such as sulfate, hydrochloride, phosphate, acetate, oxalate and borate. The group IVB metal salts include titanium tetrachloride, titanium trichloride, titanium potassium fluoride, titanium potassium oxalate, titanium sulfate, titanium tetraiodide, zirconium chloride oxide, zirconium dioxide, zirconium oxychloride, zirconium tetrachloride, etc.

The alkaline earth metal salts or the group IVB metal salts can be used singly or in combination thereof. The amount of these metal salts is preferably in the range of 0.01 to 10% by mass, more preferably 0.05 to 5.0% by mass. Silicate electrodeposition as described in US Patent No. 3,658,662 is also effective. A substrate subjected to electrolytic grain as disclosed in JP-B No. 46-27481, JP-A Nos. 52-58602 and 52-30503, and surface treatment comprising the anodizing treatment in combination with the hydrophilicity-conferring treatment, are also useful.

For the purpose of preventing tinting and improving adhesiveness between the photosensitive layer and the substrate, an intermediate layer may be arranged in the planographic printing plate precursor in the present invention. Examples of the intermediate layer which can be preferably used include those described in the following publications and specifications.

Examples of such intermediate layers include those described in JP-B No. 50-7481, JP-A Nos. 54-72104, 59-101651, 60-149491, 60-232998, 3-56177, 4-282637, 5-16558, 5-246171, 7-159983, 7-314937, 8-202025, 8-320551, 9-34104, 9-236911, 9-269593, 10-69092, 10-115931, 10-161317, 10-260536, 10-282682, 11-84674, Japanese Patent Application Laid-Open (JP-A) Nos. 8-225335, 8-270098, 9-195863, 9-195864, 9-89646, 9-106068, 9-183834, 9-264311, 9-127232, 9-245419, 10-127602, 10-170202, 11-36377, 11-165861, 11-284091, and 2000-14697.

### [Protective layer (Overcoating layer)]

In the present invention, a protective layer is preferably disposed on the photosensitive layer. The protective layer is arranged basically for protecting the photosensitive layer, and not only acts as an oxygen-impermeable layer when the photosensitive layer has an image forming mechanism in the radical polymerization system in the present invention, but also serves as an ablation-preventing layer when exposed to the light of a high-intensity infrared laser.

The desired characteristics of the protective layer are that the protective layer does not substantially inhibit transmission of light used in light exposure, is excellent in adhesion to the photosensitive layer, and can be removed easily in the development step after exposure to light. The protective layer has been devised and is described in detail in US Patent No. 3,458,311 and JP-A No. 55-49729.

The materials usable in the protective layer are preferably water-soluble polymers possessing relatively excellent crystallinity, and examples thereof include water-soluble polymers such as polyvinyl alcohol, vinyl alcohol/vinyl phthalate copolymers, vinyl acetate/vinyl alcohol/vinyl phthalate copolymers, vinyl acetate/crotonic acid copolymers, polyvinyl pyrrolidone, acidic celluloses, gelatin, gum arabic, polyacrylic acid and polyacrylamide, and these can be used alone or in admixture. Among these compounds, polyvinyl alcohol can be used as a major component to give the best result to basic characteristics such as oxygen impermeability and removability by development.

The polyvinyl alcohol (PVA) used in the protective layer may be partially replaced by ester, ether and acetal insofar as it has unsubstituted vinyl alcohol units for giving necessary oxygen impermeability and water solubility. Similarly, it may partially have other copolymerizable components.

Examples of the polyvinyl alcohol include those hydrolyzed at a degree of 71 to 100%, having 300 to 2400 repeating units. Specific examples include PVA-105, PVA-110, PVA-117, PVA-117H, PVA-120, PVA-124, PVA-124H, PVA-CS, PVA-CST, PVA-HC, PVA-203, PVA-204, PVA-205, PVA-210, PVA-217, PVA-220, PVA-224, PVA-217EE, PVA-217E, PVA-220E, PVA-224E, PVA-405, PVA-420, PVA-613, L-8, etc. which are available from Kuraray Co., Ltd.

The components (PVA selected and additives used) in the protective layer, the coating amount, etc. are selected in consideration of properties such as fogging, adhesiveness and scratch resistance, in addition to oxygen impermeability and removability by development. In general, as the degree of hydrolysis of PVA used becomes higher (or the content of unsubstituted vinyl alcohol units in the protective layer becomes higher) or as the thickness of the layer is increased, higher oxygen impermeability occurs, which is advantageous in terms of sensitivity. However, if the oxygen impermeability becomes extremely high, an undesired polymerization reaction may occur during production or storage, or unnecessary fogging and dot gain may be generated upon exposure of an image to light.

Accordingly, the oxygen permeability (A) at 25°C at 1 atmospheric pressure is preferably 0.2 ≤ A ≤ 20 (cc/m²·day).

The molecular weight of the (co)polymer such as polyvinyl alcohol is in the range of 2000 to 10,000,000, and preferably 20,000 to 3,000,000.

As other components in the protective layer, glycerin, dipropylene glycol, etc. can be added in an amount of a few percent by mass based on the polymer, in order to provide flexibility, and anionic surfactants such as sodium alkylsulfate and sodium alkylsulfonate, amphoteric surfactants such as alkylaminocarboxylates and alkylaminodicarboxylates and nonionic surfactants such as polyoxyethylene alkyl phenyl ether can be added in an amount of a few % by mass based on the (co)polymer.

The thickness of the protective layer is suitably 0.5 to 5 µm, and particularly preferably 0.5 to 2 µm.

In addition, the adhesion of the protective layer to image areas and the anti-scratch property thereof are very important for handling of the plate. That is, if a hydrophilic layer containing a water-soluble polymer is laminated on a lipophilic polymer layer, layer separation takes place easily due to insufficient adhesiveness, and the released portion causes deficiencies such as insufficient layer curing attributable to polymerization inhibition by oxygen. In order to cope with this problem, various proposals for improving the adhesiveness between the two layers have been made. For example, US Patent Application Nos. 292,501 and 44,563 describe that an acrylic emulsion, a water-insoluble vinyl pyrrolidone-vinyl acetate copolymer, etc. are mixed in an amount of 20 to 60% by mass in a hydrophilic polymer based on polyvinyl alcohol and then laminated on a polymer layer, thereby achieving satisfactory adhesiveness. Any of these known techniques can be applied to the protective layer in the present invention. The method of applying the protective layer is described in detail, for example, in US Patent No. 3,458,311 and JP-A No. 55-49729.

The process of at least light exposure and development is carried out for making a planographic printing plate from the planographic printing plate precursor of the present invention.

The light source used in the step of light exposure is preferably an IR laser, and thermal recording with a UV lamp or a thermal head is also feasible.

The planographic printing plate precursor of the present invention is preferably imagewizely exposed with infrared rays having a wavelength of 750 nm to 1400 nm emitted by a solid laser or a semiconductor laser. The output power of the laser is preferably 100 mW or more, and a multi-beam laser device is preferably used to reduce the light exposure time. The light exposure time per pixel is preferably within 20 µsec. The energy irradiated on the recording material is preferably 10 to 300 mJ/cm². When the energy for light exposure is too low, the curing of the photosensitive layer does not sufficiently proceed. When the energy for light exposure is too high, the image-recording layer may be ablated with the laser to damage the image.

The light exposure method in the invention can be carried out by overlapping beams from a light source. The term "overlapping" means that the distance between beam centers in the sub-scanning direction is smaller than the beam diameter. For example, when the beam diameter is expressed in terms of full-width half-maximum (FWHM), the overlapping can be quantitatively expressed as FWHM/distance between beam centers in the sub-scanning direction (i.e., overlapping coefficient). The overlapping coefficient in the present invention is preferably 0.1 or more.

The scanning system using a light source in the light exposure device of the present invention is not particularly limited, and known scanning methods such as a drum outer surface scanning method, a drum inner surface scanning method or a flatbed scanning method can be used. The channel of the light source may be single or multi-channel, but in the case of the drum outer surface scanning method, a multi-channel is preferably used.

In the present invention, development treatment may be carried out immediately after light-exposure, however, it is preferable that the development treatment is carried out after heat treatment, that is, that heat treatment is carried out between the light exposure step and the development step. This heat treatment is carried out preferably for between 5 seconds to 5 minutes at a temperature in the range of 60° to 150°C.

The heat treatment can be carried out by a method selected from various known methods in the art. Examples of such methods include a heating a planographic printing plate precursor functioning as the image forming material by bringing the printing plate precursor into contact with a panel heater or a ceramic heater, and, in a non-contact system, heating the printing plate precursor with a lamp or hot air. By subjecting the printing plate precursor to such heat treatment, the amount of laser energy necessary for recording an image can be reduced.

In the present invention, a pre-washing with water to remove the protective layer may be carried out before the development step. In pre-washing, tap water for example is used.

The planographic printing plate precursor of the present invention is subjected to development treatment after light exposure (or after light exposure and a heating step). The developing solution used in the developing treatment is particularly preferably an aqueous alkali solution at pH 14 or less, more preferably an aqueous alkali solution at pH 8 to 12 containing an anionic surfactant. For example, mention is made of inorganic alkalis such as tribasic sodium phosphate, tribasic potassium phosphate, tribasic ammonium phosphate, dibasic sodium phosphate, dibasic potassium phosphate, dibasic ammonium phosphate, sodium carbonate, potassium carbonate, ammonium carbonate, sodium bicarbonate, potassium bicarbonate, ammonium bicarbonate, sodium borate, potassium borate, ammonium borate, sodium hydroxide, ammonium hydroxide, potassium hydroxide and lithium hydroxide. Use is also made of organic alkalis such as monomethylamine, dimethylamine, trimethylamine, monoethylamine, diethylamine, triethylamine, monoisopropylamine, diisopropylamine, triisopropylamine, n-butylamine, monoethanolamine, diethanolamine, triethanolamine, monoisopropanolamine, diisopropanolamine, ethylene imine, ethylene diamine, and pyridine. These alkalis are used singly or in combination thereof.

In the development process of the planographic printing plate precursor of the present invention, an anionic surfactant is added in an amount of 1 to 20% by mass, preferably 3 to 10% by mass, to the developing solution. When the amount thereof is too low, the developability is deteriorated, while when the amount is too high, the strength of an image, such as abrasion resistance, may be deteriorated. The anionic surfactant includes, for example, sodium salts of lauryl alcohol sulfate, ammonium salts of lauryl alcohol sulfate, sodium salts of octyl alcohol sulfate, alkyl aryl sulfonates such as sodium isopropyl naphthalene sulfonate, sodium isobutyl naphthalene sulfonate, sodium polyoxyethylene glycol mononaphthyl ether sulfate, sodium dodecyl benzene sulfonate and sodium m-nitrobenzene sulfonate, higher alcohol sulfates having 8 to 22 carbon atoms such as sodium secondary alkyl sulfate, fatty alcohol phosphates such as sodium cetyl alcohol phosphate, alkylamide sulfonates such as C₁₇H₃₃CON(CH₃)CH₂CH₂SO₃Na, and dibasic aliphatic sulfonates such as sodium dioctyl sulfosuccinate and sodium dihexyl sulfosuccinate.

If necessary, an organic solvent such as benzyl alcohol miscible with water may be added to the developing solution. The organic solvent is preferably the one having a water solubility of about 10% by mass or less, more preferably 5% by mass or less. Examples of such organic solvents include 1-phenyl ethanol, 2-phenyl ethanol, 3-phenyl propanol, 1,4-phenyl butanol, 2,2-phenyl butanol, 1,2-phenoxy ethanol, 2-benzyloxy ethanol, o-methoxy benzyl alcohol, m-methoxy benzyl alcohol, p-methoxy benzyl alcohol, benzyl alcohol, cyclohexanol, 2-methyl cyclohexanol, 4-methyl cyclohexanol and 3-methyl cyclohexanol. The content of the organic solvent is preferably 1 to 5% by mass relative to the total mass of the developing solution used. The amount of the organic solvent used is related closely to the amount of the surfactant used, and as the amount of the organic solvent is increased, the amount of the anionic surfactant is preferably increased. This is because if the organic solvent is used in a higher amount in the presence of a smaller amount of an anionic surfactant, the organic solvent is not dissolved, thus failing to secure good developability.

If necessary, additives such as a deforming agent and hard water-softening agent can be contained. The hard water-softening agent includes, for example, polyphosphates such as Na₂P₂O₇, Na₅P₃O₃, Na₃P₃O₉, Na₂O₄P(NaO₃P)PO₃Na₂, and Calgon (sodium polymetaphosphate), aminopolycarboxylic acids (for example, ethylenediaminetetraacetic acid, potassium salt thereof, sodium salt thereof; diethylenetriaminepentaacetic acid, potassium salt thereof, sodium salt thereof; triethylenetetraminehexaacetic acid, potassium salt thereof, sodium salt thereof; hydroxyethylenediaminetriacetic acid, potassium salt thereof, sodium salt thereof; nitrilotriacetic acid, potassium salt thereof, sodium salt thereof; 1,2-diaminocyclohexanetetraacetic acid, potassium salt thereof, sodium salt thereof; 1,3-diamino-2-propanol tetraacetic acid, potassium salt thereof, sodium salt thereof); other polycarboxylic acids (for example, 2-phosphonobutanetricarboxylic acid-1,2,4, potassium salt thereof, sodium salt thereof; 2-phosphonobutanonetricarboxylic acid-2,3,4, potassium salt thereof, sodium salt thereof), organic phosphonic acids (for example, 1-phosphonoethanetricarboxylic acid-1,2,2, potassium salt thereof, sodium salt thereof; 1-hydroxyethane-1,1-diphosphonic acid, potassium salt thereof, sodium salt thereof; and aminotri(methylene phosphonic acid), potassium salt thereof, and sodium salt thereof. The optimum amount of the hard water-softening agent is varied depending on the hardness and amount of hard water used, but generally the hard water-softening agent is contained in the range of 0.01 to 5% by mass, more preferably 0.01 to 0.5% by mass, in the developing solution used.

When the planographic printing plate precursor is developed with an automatic developing machine, the developing solution is exhausted depending on throughput, and thus throughput capacity may be recovered using a replenishing solution or a fresh developing solution. In this case, the solution is replenished by a method described in US Patent No. 4,882,246. Developing solutions described in JP-A Nos. 50-26601, 58-54341, JP-B Nos. 56-39464, 56-42860 and 57-7427 are also preferable.

The planographic printing plate precursor which was subjected in this manner to development process is post-treated with washing water, a surfactant-containing rinse, and a desensitizing solution containing gum arabic and starch derivatives, as described in JP-A Nos. 54-8002, 55-115045 and 59-58431. These treatments can be used in combination as post-treatment of the planographic printing plate precursor of the present invention.

In the method of producing the planographic printing plate precursor of the present invention, the whole surface to heating of the images after development is subjected to heating or light exposure for the purpose of improving strength of image areas and printing durability.

Very severe conditions can be utilized in heating after development. Usually, heating is carried out in the range of 200 to 500°C. When the heating temperature after development is low, a sufficient image area strengthening effect cannot be achieved, while when the temperature is too high, there may arise problems such as deterioration of the substrate and thermal degradation of the image areas.

The planographic printing plate obtained by these treatments is loaded onto an offset printing machine, etc. and used for printing on a large number of papers.

At the time of printing, a plate cleaner used for dirt removal from the plate includes PS plate cleaners known in the art, such as CL-1, CL-2, CP, CN-4, CN, CG-1, PC-1, SR and IC (Fuji Photo Film Co., Ltd.).

### EXAMPLES

Hereinafter, the present invention will be described with reference to the following examples, but the present invention is not limited thereto.

### [Examples 1 to 10, Comparative Example 1]

### [Preparation of a substrate]

### <Aluminum plate>

An aluminum alloy containing 0.06% by mass Si, 0.30% by mass Fe, 0.001% by mass Cu, 0.001% by mass Mn, 0.001% by mass Mg, 0.001% by mass Zn and 0.03% by mass Ti, the balance being Al and inevitable impurities, was used to prepare a melt, then subjected to a molten metal treatment, filtered and formed into an ingot of 500 mm in thickness and 1200 mm in width with a DC casting method. After its surface layer of 10 mm in average thickness was shaved with a surface shaving machine, the ingot was kept at 550°C for about 5 hours, and when the temperature was reduced to 400°C, the ingot was formed into a rolled plate of 2.7 mm in thickness with a hot rolling mill. Then, the plate was subjected to heat treatment at 500°C with a continuous annealing device and finished in cold rolling to give the plate a thickness of 0.24 mm as an aluminum plate of JIS 1050 material. This aluminum plate was formed into a plate of 1030 mm in width and then subjected to the following surface treatment.

### <Surface treatment>

In the surface treatment, the following treatments (a) to (j) were successively conducted. After each treatment and water washing, all remaining liquid was removed with nip rollers.

### (a) Mechanical surface roughening treatment

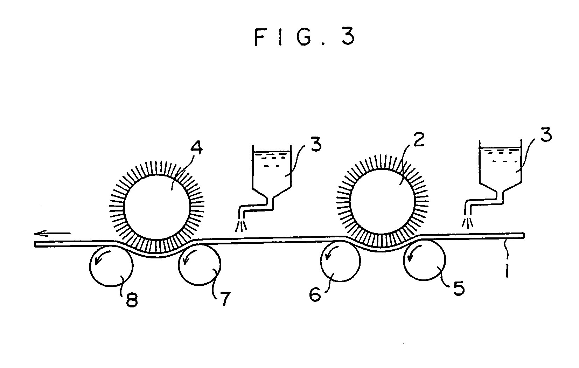

Using the device shown in Fig. 3, the surface of the aluminum plate was subjected to mechanical surface roughening treatment with a rotating roller-shaped nylon brush while being supplied with an aqueous suspension of an abrasive having a specific gravity of 1.12 (Pamis) as an abrasive slurry. In Fig. 3, 1 is the aluminum plate, 2 and 4 are roller-shaped brushes, 3 is the abrasive slurry, and 5, 6, 7 and 8 are supporting rollers. The average particle diameter of the abrasive was 30 µm, and the maximum particle diameter was 100 µm. The nylon brush was made of 6·10 nylon, the length of the brush bristle was 45 mm, and the diameter of the brush bristle was 0.3 mm. The nylon brush had bristles arranged densely in holes in a stainless steel cylinder of φ300 mm.
Three rotating brushes were used. The distance between the two supporting rollers (φ200 nm) under the brushes was 300 mm. The brush roller was pressed against the aluminum plate until the loading of a driving motor for rotating the brush was increased to 7 kW plus relative to the loading before the brush roller was pressed against the aluminum plate. The direction of rotation of the brush was the same as the transporting direction of the aluminum plate. The number of revolutions of the brush was 200 rpm.

### (b) Alkali etching treatment

The aluminum plate obtained above was subjected to etching treatment by spraying with an aqueous solution of sodium hydroxide at a concentration of 2.6% by mass and aluminum ion at a concentration of 6.5% by mass at a temperature of 70°C, whereby the aluminum plate was dissolved in an amount of 10 g/m². Thereafter, the aluminum plate was washed by spraying with water.

### (c) Desmut treatment

The aluminum plate was subjected to desmut treatment with an aqueous solution (containing 0.5% by mass aluminum ion) of 1% by mass nitric acid at a temperature of 30°C and then washed by spraying with water. The aqueous solution of nitric acid used in desmut treatment was a waste liquid in the step of electrochemical surface roughening treatment with an alternating current in an aqueous solution of nitric acid.

### (d) Electrochemical surface roughening treatment

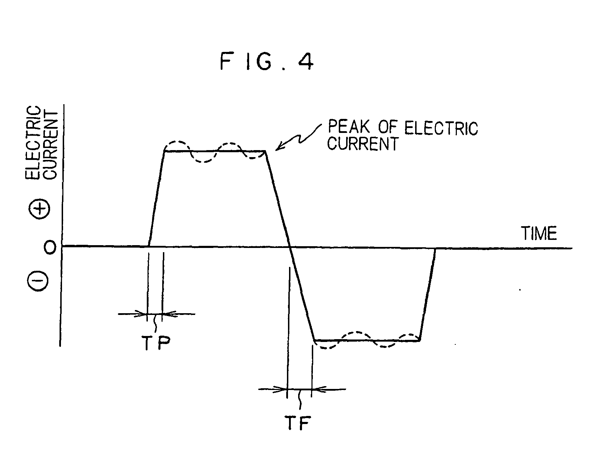

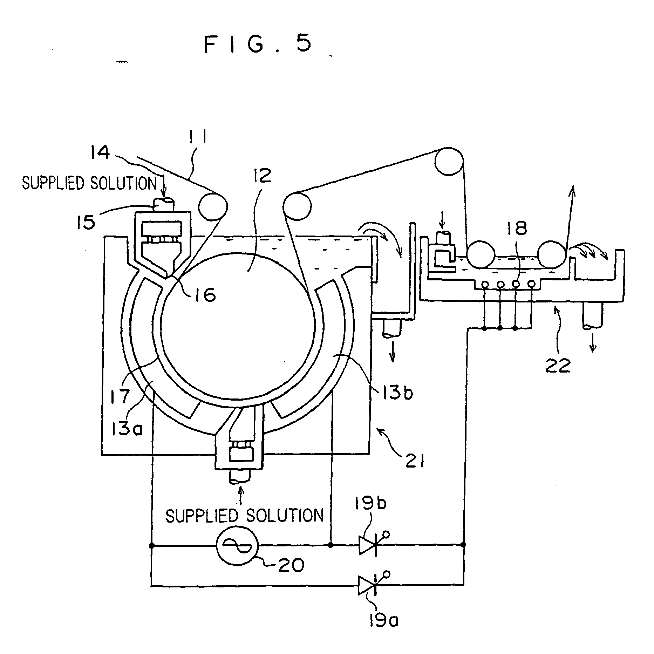

The plate was continuously subjected to electrochemical surface roughening treatment with an alternating voltage of 60 Hz. The electrolytic solution used was 10.5 g/L aqueous nitric acid solution (containing 5 g/L aluminum ion and 0.007% by mass ammonium ion) at a temperature of 50°C. The alternating current power source waveform is shown in Fig. 4, and the electrochemical surface roughening treatment was carried out with a carbon electrode as a counter electrode, wherein the time TP required for the electric current to reach from 0 to the peak was 0.8 msec., the duty ratio was 1:1 and a trapezoid rectangular wave alternating current was used. Ferrite was used as an auxiliary anode. The electrolytic bath used is shown in Fig. 5. In Fig. 5, Numeral 11 denotes an aluminum plate, 12 denotes a radial drum roller, 13a and 13b denote main electrodes, 14 denotes an electrolytic solution, 15 denotes an electrolytic solution supplying inlet, 16 denotes a slit, 17 denotes an electrolytic solution passage, 18 denotes an auxiliary anode, 19a and 19b denote thyristors, 20 denotes an alternate power source, 21 denotes a main electrolytic bath, and 22 denotes an auxiliary anode bath.

The current density was 30 A/dm² in terms of the electric current peak, and the electrical quantity was 220 C/dm² in terms of the total electrical quantity upon anodizing of the aluminum plate. An effective shunt current of 5% of the electric current from the power source was fed to the auxiliary anode. Thereafter, the plate was washed by spraying with water.

### (e) Alkali etching treatment

The aluminum plate was subjected to etching treatment by spraying with an aqueous solution of sodium hydroxide at a concentration of 26% by mass and aluminum ion at a concentration of 6.5% by mass at a temperature of 32°C, whereby the aluminum plate was dissolved in an amount of 0.50 g/m², and smut components based on aluminum hydroxide formed by the electrochemical surface roughening treatment using the alternating current in the previous stage were removed, and the edge of the formed pit was dissolved to smooth the edge. Thereafter, washing by spraying with water was carried out.

### (f) Desmut treatment

The aluminum plate was subjected to desmut treatment with an aqueous solution (containing 4.5% by mass aluminum ion) of 15% by mass nitric acid at a temperature of 30°C and then washed by spraying with water. The aqueous solution of nitric acid used in desmut treatment was waste liquid in the step of electrochemical surface roughening treatment with an alternating current in an aqueous solution of nitric acid.

### (g) Electrochemical surface roughening treatment

The plate was subjected continuously to electrochemical surface roughening treatment with an alternating voltage of 60 Hz. The electrolyte used was 5.0 g/L aqueous hydrochloric acid solution (containing 5 g/L aluminum ion) at a temperature of 35°C. The alternating current power source waveform is shown in Fig. 5, and the electrochemical surface roughening treatment was carried out with a carbon electrode as a counter electrode, wherein the time TP required for the electric current to reach from 0 to the peak was 0.8 msec., the duty ratio was 1:1 and a trapezoid rectangular wave alternating current was used. Ferrite was used as an auxiliary anode. The electrolytic bath used is shown in Fig. 5.

The current density was 25 A/dm² in terms of the electric current peak, and the electrical quantity was 50 C/dm² in terms of the total electrical quantity upon anodizing of the aluminum plate. Thereafter, the plate was washed by spraying with water.

### (h) Alkali etching treatment

The aluminum plate was subjected to etching treatment by spraying with an aqueous solution of sodium hydroxide at a concentration of 26% by mass and aluminum ion at a concentration of 6.5% by mass at a temperature of 32°C, whereby the aluminum plate was dissolved in an amount of 0.10 g/m², and smut components based on aluminum hydroxide formed by the electrochemical surface roughening treatment using the alternating current in the previous stage were removed, and the edge of the formed pit was dissolved to smooth the edge. Thereafter, washing by spraying with water was carried out.

### (i) Desmut treatment

The aluminum plate was subjected to desmut treatment with an aqueous solution (containing 0.5% by mass aluminum ion) of 25% by mass sulfuric acid at a temperature of 60°C and then washed by spraying with water.

### (j) Anodizing treatment

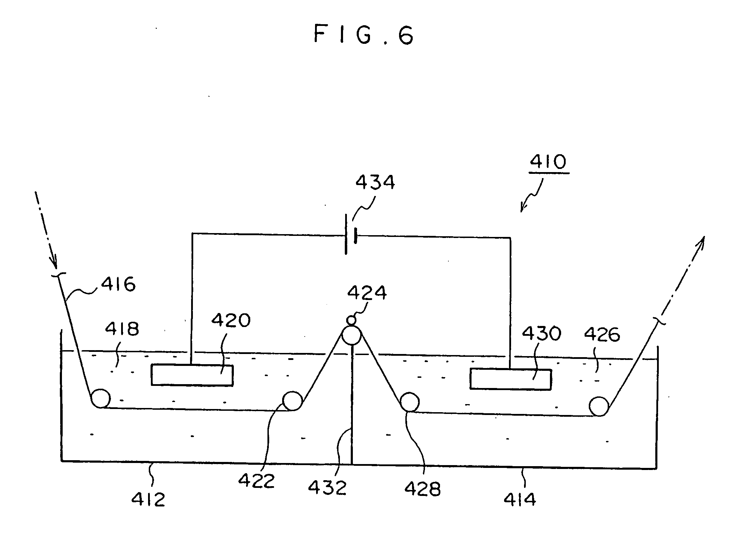

Anodizing treatment was carried out with an anodizing device having the structure shown in Fig. 6 to provide a substrate for planographic printing. In Fig. 6, Numeral 410 denotes an anodizing treatment device, 412 denotes a power supplying bath, 414 denotes an electrolytic bath, 416 denotes an aluminum plate, 418 and 426 denotes electrolytic solutions, 420 denotes a power supplying electrode, 422 and 428 denote rollers, 424 denotes nip rollers, 430 denotes an electrolytic electrode, 432 denotes a bath wall, and 434 denotes a direct current power source.

The electrolytic solution supplied to the first and second electrolytic zones were sulfuric acid solution. Both the electrolytes were 170 g/L sulfuric acid (containing 0.5% by mass aluminum ion) at a temperature of 38°C. Thereafter, washing by spraying with water was carried out. The final anodized coating was 2.7 g/m².

The Ra of the substrate obtained by the above treatment was 0.45.

### [Undercoat]

Next, an undercoat solution shown below was applied by use of a wire bar onto the aluminum substrate and dried at 90°C for 30 seconds in a hot-air drying oven. The amount of the coating after drying was 10 mg/m².

### <Undercoat solution>

· Ethyl acrylate/sodium 2-acrylamide-2-methyl-1-propanesulfonate copolymer (molar ratio 75:15) 0.1 g
· 2-Aminoethylphosphonic acid 0.1 g
· Methanol 50 g
· Deionized water 50 g

### [Photosensitive layer]

Next, the photosensitive layer coating solution [P-1] below was prepared and applied by the use of a wire bar onto the aluminum substrate which had been coated with the undercoat described above. The solution was dried at 122°C for 43.5 seconds in a hot-air drying oven to form a photosensitive layer. The coating amount after drying was 1.4 g/m².

### <Photosensitive layer coating solution [P-1]>

· Infrared ray absorber (IR-1) 0.08 g
· Polymerization initiator (OS-1) 0.25 g
· Polymerizable compound
   type and content (g) shown in Table 1
· Binder polymer (BT-1) 1.00 g
· Ethyl Violet chloride 0.04 g
· Fluorine-type surfactant
   (MEGAFAC F-780-F from Dainippon Ink and Chemicals, Inc.) 0.03 g
· Trimellitic acid 0.1 g
· Methyl ethyl ketone 10.4 g
· Methanol 4.83 g
· 1-Methoxy-2-propanol 10.4 g

The structures of the infrared absorbing agent (IR-1), the polymerization initiator (OS-1), and the binder (BT-1) used in the photosensitive layer coating solution are shown below:

### Infrared absorbing agent (IR-1)

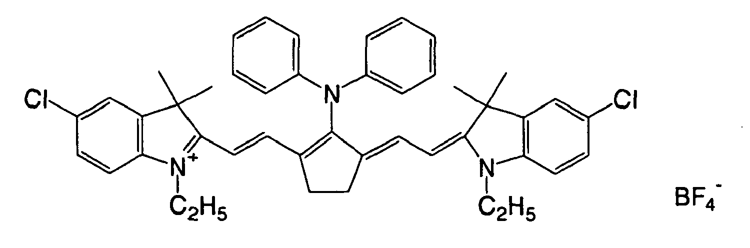

### Polymerization initiator (IS-1)

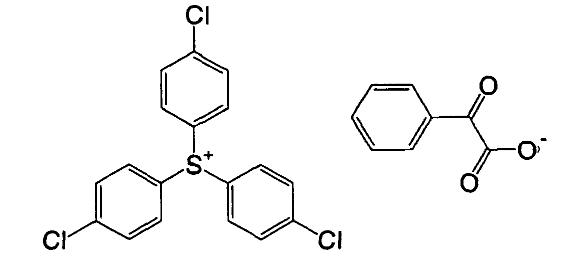

### Binder polymer (BT-1)

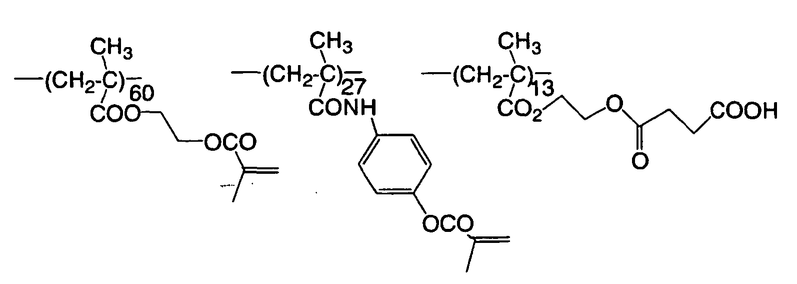

### [Protective layer (overcoat layer)]

An aqueous mixed solution of polyvinyl alcohol (degree of saponification, 98% by mole; degree of polymerization of 500) and polyvinyl pyrrolidone (Rubiscol K-30 manufactured by BASF) was applied onto the surface of the photosensitive layer by the use of a wire bar and dried at 125°C for 75 seconds in a hot-air drying oven. The content of PVA was 85% by mass, and the coating amount (coating amount after drying) was 1.5 g/m². The coefficient of dynamic friction of the surface of the protective layer was 0.45.

The planographic printing plate precursors in Examples 1 to 10 and Comparative Example 1 were obtained in the manner described above.

### [Evaluation]

### (1) Evaluation of sensitivity

The resultant planographic printing plate precursor was exposed to light with output power in the range of 0 to 8 W changed by 0.15 in log E with a resolution of 175 1pi at an outer drum revolution number of 150 rpm by Trendsetter-3244VX (from CREO Co., Ltd.) equipped with a water-cooling 40-W infrared semiconductor laser. Light exposure was carried out under the condition of 50% RH at 25°C. After the light exposure, the protective layer was removed with washing with tap water, and development was carried out at 30°C for 12 seconds in an automatic developing machine LP-1310HII manufactured by Fuji Photo Film Co., Ltd. A dilution of DV-2 (Fuji Photo Film Co., Ltd.) with water in a ratio of 1:4 was used as the developing solution, and a dilution of FP-2W (Fuji Photo Film Co., Ltd.) with water in a ratio of 1:1 was used as the finisher.

The density of the developed image portion of the planographic printing plate was measured with a Macbeth reflection densitomer RD-918, and a red filter attached to the densitomer was used to measure the cyan density. A reciprocal number of the amount of exposure light necessary for attaining a density of 0.8 was evaluated as sensitivity. Assuming that the sensitivity of the planographic printing plate obtained in Comparative Example 1 was regarded as 100, the evaluation results of the other planographic printing plates are shown in relative sensitivity. A higher value is indicative of higher sensitivity. The results are shown in Table 1.

### (2) Evaluation of raw stock storability

The unexposed planographic printing plate precursor was stored at 25°C under 50% RH for 2 hours fin order to regulate the humidity, and sealed with an aluminum kraft paper and stored at 50°C for 3 days, and subjected to light exposure and development in the following method, and the density of the non-image area was measured by a Macbeth reflection densitomer RD-918. The planographic printing plate precursor just after preparation was also subjected to light exposure and development in the same manner, and the density of the non-image area was measured. In the examples, the different Δfog between the non-image areas was determined and used as an indicator of raw stock storability. A smaller Δfog value indicates higher raw stock storability, and 0.02 or less is a practically usable level. The results are shown in Table 1.

### (Light exposure/development)

A solid image with a resolution of 175 1pi on the planographic printing plate precursor was exposed to light with an output power of 8 W at an outer drum revolution number of 206 rpm with an energy of 100 mJ/cm² on the printing matrix by Trendsetter-3244VX (from CREO Co., Ltd.) equipped with a water-cooling 40-W infrared semiconductor laser. After the light exposure, the protective layer was removed with washing with tap water, and the image was developed in the same method as in (1) Evaluation of sensitivity above.

### (3) Evaluation of printing durability

80% screen tint image with a resolution of 175 1pi on the prepared planographic printing plate precursor was exposed to light with an output power of 8 W at an outer drum revolution number of 206 rpm with an energy of 100 mJ/cm² on the printing matrix by Trendsetter-3244VX (Creo) equipped with a water-cooling 40-W infrared semiconductor laser. After the light exposure, the protective layer was removed with washing with tap water, and the image was developed in the same method as in (1) Evaluation of sensitivity above. The resulting planographic printing plate was used in printing with a printing machine Lithron manufactured by Komori Corporation, while the ink was wiped from the surface of the printing plate after printing of every 10,000 prints. The number of complete prints was regarded as an indicator of printing durability. The results are shown in Table 1.

**Table 1**

| | Polymerizable compound | Content (g) | Sensitivity 25°C50%RH | Raw stock storability Δ fog | Printing durability (number of prints) |
|---|---|---|---|---|---|
| Example 1 | M-3 | 1 | 115 | ±0 | 100,000 |
| Example 2 | M-5 | 1 | 120 | 0.01 | 100,000 |
| Example 3 | M-10 | 1 | 115 | 0.01 | 100,000 |
| Example 4 | M-13 | 1 | 115 | 0.01 | 100,000 |
| Example 5 | M-16 | 1 | 110 | ±0 | 90,000 |
| Example 6 | M-18 | 1 | 130 | 0.01 | 100,000 |
| Example 7 | M-21 | 1 | 110 | 0.01 | 90,000 |
| Example 8 | M-23 | 1 | 125 | 0.01 | 120,000 |
| Example 9 | M-13 | 0.8 | 110 | 0.01 | 100,000 |
| | Dipentaerythritol hexaacrylate | 0.2 | | | |
| Example 10 | M-3 | 0.8 | 110 | ±0 | 100,000 |
| | Dipentaerythritol hexaacrylate | 0.2 | | | |
| Comparative Example 1 | Dipentaerythritol hexaacrylate | 1 | 100 | 0.01 | 50000 |

As is evident from Table 1, it was found that the planographic printing plate precursors in Examples 1 to 10exhibit excellent sensitivity, raw stock storability, and printing durability. In contrast, the planographic printing plate precursor in Comparative Example 1 had raw stock storability, but was problematic on a practical level and inferior in sensitivity and printing durability, particularly printing durability.

According to the present invention, there can be provided a photosensitive composition which is highly sensitive, excellent in storage stability (raw stock storability) and useful as a photosensitive layer of a negative planographic printing plate precursor, as described above. According to the present invention, there can also be provided a negative planographic printing plate precursor which is capable of highly sensitive recording with an infrared laser and excellent in storage stability (row stock storability) and printing durability.

## Claims

1. A photosensitive composition comprising an infrared absorbing agent, a polymerization initiator, a polymerizable compound and a binder polymer, wherein the composition comprises a sulfonium salt polymerization initiator and a polymerizable compound having a urethane skeleton, **characterized in that** the sulfonium salt polymerization initiator is an onium salt represented by the following general formula (I): 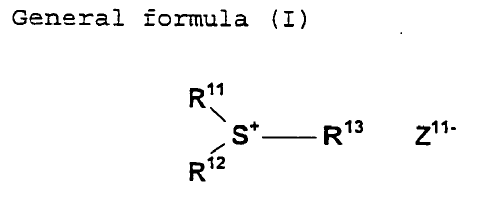 wherein R¹¹, R¹² and R¹³ each represent parachlorophenyl group; and Z¹¹⁻ represents a counterion selected from the group consisting of a carboxylate ion and a sulfonate ion,
with the proviso that in the photosensitive composition the following compound (1) may not be contained in combination with the following compound (2):

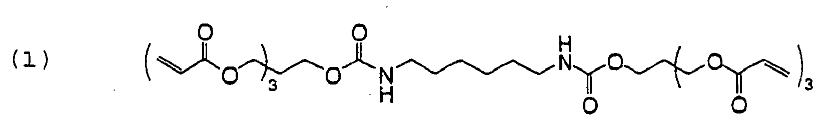

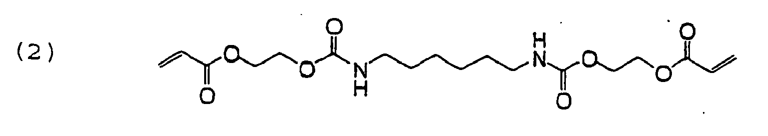

2. A photosensitive composition according to claim 1, wherein the polymerizable compound having a urethane skeleton is an addition-polymerizable compound having at least one urethane linkage and at least one ethylenically unsaturated bond.

3. A photosensitive composition according to claim 2, wherein the addition-polymerizable compound has two or more ethylenically unsaturated bonds.

4. A photosensitive composition according to claim 1, wherein the binder polymer has a repeating unit represented by the following general formula (i): 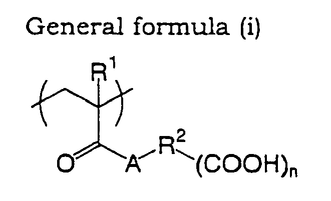 wherein R¹ represents a hydrogen atom or a methyl group; R² represents a linking group composed of two or more atoms selected from the group consisting of a carbon atom, a hydrogen atom, an oxygen atom, a nitrogen atom and a sulfur atom, and wherein the total number of atoms in R² is 2 to 82; A represents an oxygen atom or -NR³- in which R³ represents a hydrogen atom or a monovalent hydrocarbon group having 1 to 10 carbon atoms; and n is an integer from 1 to 5.

5. A photosensitive composition according to claim 1, wherein the infrared absorbing agent is a dye having an absorption maximum at a wavelength of 700 to 1200 nm.

6. A photosensitive composition according to claim 5, wherein the infrared absorbing agent is selected from the group consisting of cyanine dyes, phthalocyanine dyes, oxonol dyes, squarylium dyes, pyrylium salts, thiopyrylium dyes and nickelthiolate complexes.

7. A planographic printing plate precursor comprising a photosensitive layer disposed on a substrate, wherein the photosensitive layer including the photosensitive composition according to claim 1.

8. A planographic printing plate precursor according to claim 7, wherein a protective layer is disposed on the photosensitive layer.

9. A planographic printing plate precursor according to claim 7, wherein the polymerizable compound having a urethane skeleton is an addition-polymerizable compound having at least one urethane linkage and at least one ethylenically unsaturated bond.

10. A planographic printing plate precursor according to claim 9, wherein the addition-polymerizable compound has two or more ethylenically unsaturated bonds.

11. A planographic printing plate precursor according to claim 7, wherein the binder polymer has a repeating unit represented by the following general formula (i): 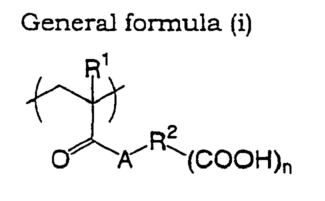 wherein R¹ represents a hydrogen atom or a methyl group; R² represents a linking group composed of two or more atoms selected from the group consisting of a carbon atom, a hydrogen atom, an oxygen atom, a nitrogen atom and a sulfur atom, and wherein the total number of atoms in R² is 2 to 82; A represents an oxygen atom or -NR³- in which R³ represents a hydrogen atom or a monovalent hydrocarbon group having 1 to 10 carbon atoms; and n is an integer from 1 to 5.

12. A planographic printing plate precursor according to claim 7, wherein the infrared absorbing agent is a dye having an absorption maximum at a wavelength of 700 to 1200 nm.

13. A planographic printing plate precursor according to claim 12, wherein the infrared absorbing agent is selected from the group consisting of cyanine dyes, phthalocyanine dyes, oxonol dyes, squarylium, dyes, pyrylium salts, thiopyrylium dyes and nickelthiolate complexes.

14. A planographic printing plate precursor according to claim 7, wherein a coating amount of the photosensitive layer after drying is 0.1 to 10 g/m².

15. A planographic printing plate precursor according to claim 8, wherein the protective layer contains polyvinyl alcohol as a major component.

16. A planographic printing plate precursor according to claim 7, wherein the planographic printing plate precursor is subjected to imagewise exposure with laser light having a wavelength of 750 to 1400 nm.

## Patentansprüche

1. Lichtempfindliche Zusammensetzung, die einen Infrarotabsorber, einen Polymerisationsstarter, eine polymerisierbare Verbindung und ein Binderpolymer umfasst, worin die Zusammensetzung einen Sulfoniumsalz-Polymerisationsstarter und eine polymerisierbare Verbindung mit einem Urethangerüst umfasst, und **dadurch gekennzeichnet ist, dass** der Sulfoniumsalz-Polymerisationsstarter ein Oniumsalz der folgenden allgemeinen Formel (I) ist: 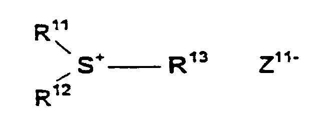 worin R¹¹, R¹² und R¹³ jeweils eine Parachlorphenylgruppe ist; und Z¹¹⁻ ein Gegenion ist, das ausgewählt ist aus einem Carboxylation und einem Sulfonation, vorausgesetzt, dass die lichtempfindliche Zusammensetzung die folgende Verbindung (1) nicht in Kombination mit der folgenden Verbindung (2) enthalten sein kann:

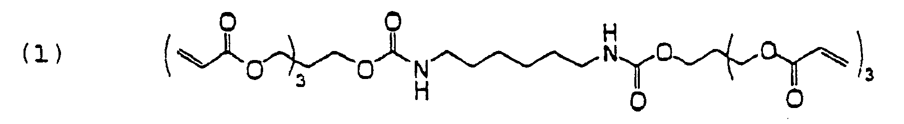

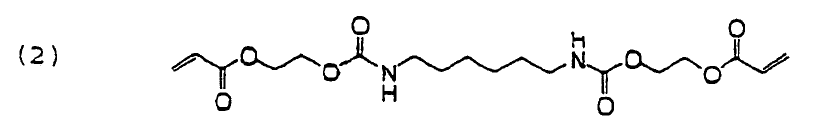

2. Lichtempfindliche Zusammensetzung gemäß Anspruch 1, worin die polymerisierbare Verbindung mit einem Urethangerüst eine additionspolymerisierbare Verbindung mit mindestens einer Urethanverknüpfung und mindestens einer ethylenisch ungesättigten Bindung ist.

3. Lichtempfindliche Zusammensetzung gemäß Anspruch 2, worin die additionspolymerisierbare Verbindung zwei oder mehr ethylenisch ungesättigte Bindungen aufweist.

4. Lichtempfindliche Zusammensetzung gemäß Anspruch 1, worin das Binderpolymer Wiederholungseinheiten der folgenden allgemeinen Formel (i) aufweist: 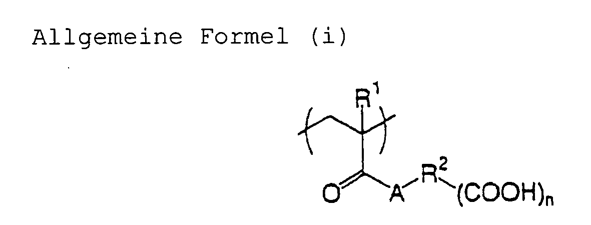 worin R¹ ein Wasserstoffatom oder eine Methylgruppe ist; R² eine Verknüpfungsgruppe ist, die aus zwei oder mehr Atomen zusammengesetzt ist, welche ausgewählt sind aus einem Kohlenstoffatom, einem Wasserstoffatom, einem Sauerstoffatom, einem Stickstoffatom und einem Schwefelatom, und worin die Gesamtanzahl der Atome in R² 2 bis 82 ist; A ein Sauerstoffatom oder -NR³- ist, in dem R³ ein Wasserstoffatom oder eine monovalente Kohlenwasserstoffgruppe mit 1 bis 10 Kohlenstoffatomen ist; und n eine ganze Zahl von 1 bis 5 ist.

5. Lichtempfindliche Zusammensetzung gemäß Anspruch 1, worin der Infrarotabsorber ein Farbstoff mit einem Absorptionsmaximum bei einer Wellenlänge von 700 bis 1.200 nm ist.

6. Lichtempfindliche Zusammensetzung gemäß Anspruch 5, worin der Infrarotabsorber ausgewählt ist aus Cyaninfarbstoffen, Phthalocyaninfarbstoffen, Oxonolfarbstoffen, Squariliumfarbstoffen, Pyryliumsalzen, Thiopyryliumfarbstoffen und Nickelthiolatkomplexen.

7. Flachdruckplattenvorläufer, der eine lichtempfindliche Schicht auf einem Träger umfasst, worin die lichtempfindliche Schicht die lichtempfindliche Zusammensetzung gemäß Anspruch 1 einschließt.

8. Flachdruckplattenvorläufer gemäß Anspruch 7, worin eine Schutzschicht auf der lichtempfindlichen Schicht angeordnet ist.

9. Flachdruckplattenvorläufer gemäß Anspruch 7, worin die polymerisierbare Verbindung mit einem Urethangerüst eine additionspolymerisierbare Verbindung mit mindestens einer Urethanverknüpfung und mindestens einer ethylenisch ungesättigten Bindung ist.

10. Flachdruckplattenvorläufer gemäß Anspruch 9, worin die additionspolymerisierbare Verbindung zwei oder mehr ethylenisch ungesättigte Bindungen aufweist.

11. Flachdruckplattenvorläufer gemäß Anspruch 7, worin das Binderpolymer Wiederholungseinheiten der folgenden allgemeinen Formel (i) aufweist: 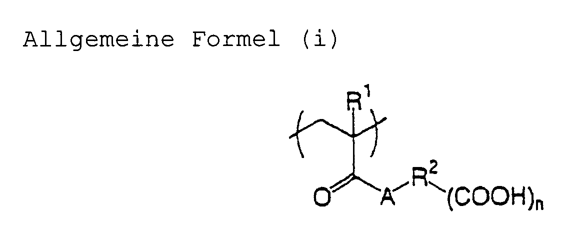 worin R¹ ein Wasserstoffatom oder eine Methylgruppe ist; R² eine Verknüpfungsgruppe ist, die aus zwei oder mehr Atomen zusammengesetzt ist, welche ausgewählt sind aus einem Kohlenstoffatom, einem Wasserstoffatom, einem Sauerstoffatom, einem Stickstoffatom und einem Schwefelatom, und worin die Gesamtanzahl der Atome in R² 2 bis 82 ist; A ein Sauerstoffatom oder -NR³- ist, in dem R³ ein Wasserstoffatom oder eine monovalente Kohlenwasserstoffgruppe mit 1 bis 10 Kohlenstoffatomen ist; und n eine ganze Zahl von 1 bis 5 ist.

12. Flachdruckplattenvorläufer gemäß Anspruch 7, worin der Infrarotabsorber ein Farbstoff mit einem Absorptionsmaximum bei einer Wellenlänge von 700 bis 1.200 nm ist.

13. Flachdruckplattenvorläufer gemäß Anspruch 12, worin der Infrarotabsorber ausgewählt ist aus Cyaninfarbstoffen, Phthalocyaninfarbstoffen, Oxonolfarbstoffen, Squaryliumfarbstoffen, Pyryliumsalzen, Thiopyryliumfarbstoffen und Nickelthiolatkomplexen.

14. Flachdruckplattenvorläufer gemäß Anspruch 7, worin eine Beschichtungsmenge der lichtempfindlichen Schicht nach dem Trocknen 0,1 bis 10 g/m² ist.

15. Flachdruckplattenvorläufer gemäß Anspruch 8, worin die Schutzschicht Polyvinylalkohol als Hauptkomponente enthält.

16. Flachdruckplattenvorläufer gemäß Anspruch 7, worin der Flachdruckplattenvorläufer einer bildweisen Belichtung mit Laserlicht mit einer Wellenlänge von 750 bis 1.400 nm unterzogen ist.

## Revendications

1. Composition photosensible, comprenant un agent absorbant les infrarouges, un initiateur de polymérisation, un composé polymérisable et un liant polymère, dans laquelle la composition comprend un initiateur de polymérisation de type sel de sulfonium et un composé polymérisable possédant un squelette uréthane, **caractérisée en ce que** l'initiateur de polymérisation de type sel de sulfonium est un sel d'onium représenté par la formule générale (I) suivante : 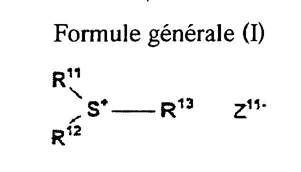 dans laquelle R¹¹, R¹² et R¹³ représentent chacun un groupe parachlorophényle ; et Z¹¹⁻ représente un contre-ion choisi dans le groupe constitué par un ion carboxylate et un ion sulfonate,
à condition que le composé (1) suivant ne puisse pas être contenu dans la composition photosensible en combinaison avec le composé (2) suivant :

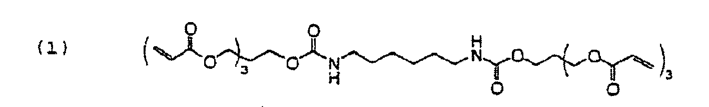

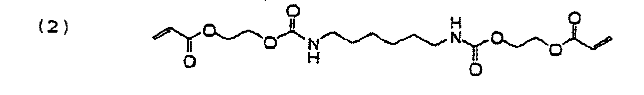

2. Composition photosensible selon la revendication 1, dans laquelle le composé polymérisable possédant un squelette uréthane est un composé polymérisable par addition contenant au moins une liaison uréthane et au moins une liaison de type insaturation éthylénique.

3. Composition photosensible selon la revendication 2, dans laquelle le composé polymérisable par addition contient deux ou plus de deux liaisons de type insaturation éthylénique.

4. Composition photosensible selon la revendication 1, dans laquelle le liant polymère contient un motif répétitif représenté par la formule générale (i) suivante : 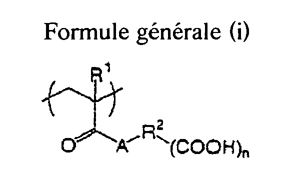 dans laquelle R¹ représente un atome d'hydrogène ou un groupe méthyle ; R² représente un groupe de liaison composé de deux ou plus de deux atomes choisis dans le groupe constitué par un atome de carbone, un atome d'hydrogène, un atome d'oxygène, un atome d'azote et un atome de soufre, et dans laquelle le nombre total d'atomes dans R² va de 2 à 82 ; A représente un atome d'oxygène ou -NR³- dans lequel R³ représente un atome d'hydrogène ou un groupe hydrocarboné monovalent contenant 1 à 10 atome de carbone ; et n est un nombre entier allant de 1 à 5.

5. Composition photosensible selon la revendication 1, dans laquelle l'agent absorbant les infrarouges est un colorant présentant un maximum d'absorption à une longueur d'onde de 700 nm à 1200 nm.

6. Composition photosensible selon la revendication 5, dans laquelle l'agent absorbant les infrarouges est choisi dans le groupe constitué par les colorants de cyanine, les colorants de phtalocyanine, les colorants d'oxonol, les colorants de squarylium, les sels de pyrylium, les colorants de thiopyrylium et les complexes thiolate de nickel.

7. Précurseur de plaque d'impression planographique, comprenant une couche photosensible disposée sur un substrat, la couche photosensible comprenant la composition photosensible selon la revendication 1.

8. Précurseur de plaque d'impression planographique selon la revendication 7, dans lequel une couche protectrice est disposée sur la couche photosensible.

9. Précurseur de plaque d'impression planographique selon la revendication 7, dans lequel le composé polymérisable possédant un squelette d'uréthane est un composé polymérisable par addition contenant au moins une liaison uréthane et au moins une liaison de type insaturation éthylénique.

10. Précurseur de plaque d'impression planographique selon la revendication 9, dans lequel le composé polymérisable par addition contient deux ou plus de deux liaisons de type insaturation éthylénique.

11. Précurseur de plaque d'impression planographique selon la revendication 7, dans lequel le liant polymère contient un motif répétitif représenté par la formule générale (i) suivante : 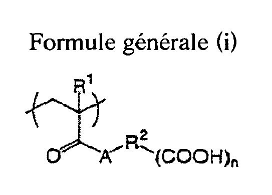 dans laquelle R¹ représente un atome d'hydrogène ou un groupe méthyle ; R² représente un groupe de liaison composé de deux ou plus de deux atomes choisis dans le groupe constitué par un atome de carbone, un atome d'hydrogène, un atome d'oxygène, un atome d'azote et un atome de soufre, et dans laquelle le nombre total d'atomes dans R² va de 2 à 82 ; A représente un atome d'oxygène ou -NR³- dans lequel R³ représente un atome d'hydrogène ou un groupe hydrocarboné monovalent contenant 1 à 10 atome de carbone ; et n est un nombre entier allant de 1 à 5.

12. Précurseur de plaque d'impression planographique selon la revendication 7, dans lequel l'agent absorbant les infrarouges est un colorant présentant un maximum d'absorption à une longueur d'onde de 700 nm à 1200 nm.

13. Précurseur de plaque d'impression planographique selon la revendication 12, dans lequel l'agent absorbant les infrarouges est choisi dans le groupe constitué par les colorants de cyanine, les colorants de phtalocyanine, les colorants d'oxonol, les colorants squarylium, les sels de pyrylium, les colorants de thiopyrylium et les complexes thiolate de nickel.

14. Précurseur de plaque d'impression planographique selon la revendication 7, dans lequel une quantité de revêtement de la couche photosensible après séchage est de 0,1 g/m² à 10 g/m².

15. Précurseur de plaque d'impression planographique selon la revendication 8, dans lequel la couche protectrice contient un poly(alcool vinylique) en tant que composant principal.

16. Précurseur de plaque d'impression planographique selon la revendication 7, dans lequel le précurseur de plaque d'impression planographique est soumis à une exposition formant image avec une lumière laser possédant une longueur d'onde de 750 nm à 1400 nm.
